# EUROPEAN PATENT APPLICATION

(11) **EP 4 738 426 A1**
(43) Date of publication of application: **06.05.2026**
(21) Application number: 24831942.8
(22) Date of filing: 25.06.2024
(51) Int. Cl.: H01L 21/304

(54) **SUBSTRATE PROCESSING METHOD AND SUBSTRATE PROCESSING APPARATUS**

(30) Priority: 29.06.2023 JP 2023106666
(71) Applicant: SCREEN Holdings Co., Ltd., Kyoto-shi, Kyoto 602-8585 (JP)
(72) Inventor: TAKEMATSU, Yusuke, Kyoto-shi, Kyoto 602-8585 (JP); KATO, Masahiko, Kyoto-shi, Kyoto 602-8585 (JP); ISHIZU, Takaaki, Kyoto-shi, Kyoto 602-8585 (JP); NAKANO, Akiyoshi, Kyoto-shi, Kyoto 602-8585 (JP); MIZUKAMI, Daijo, Kyoto-shi, Kyoto 602-8585 (JP); IWAKAWA, Yutaka, Kyoto-shi, Kyoto 602-8585 (JP); SHIRAO, Takashi, Kyoto-shi, Kyoto 602-8585 (JP)
(74) Representative: Kilian Kilian & Partner mbB
(86) International application number: PCT/JP2024/022994
(87) International publication number: WO 2025/005082

(57) **Abstract**

Provided is a technique capable of reducing a collapse rate of a pattern of a peripheral edge portion of a substrate. A substrate processing method includes a holding step, a liquid processing step, and a drying step. In the holding step, a substrate is held. In the liquid processing step, a processing liquid is supplied to a first main surface (Wa) of a substrate (W). In a drying liquid supply step, after the liquid processing step, while the substrate (W) is rotated and a second main surface (Wb) of the substrate (W) is heated, a drying liquid having a surface tension lower than that of the processing liquid is supplied to the first main surface (Wa) of the substrate (W). During at least a part of the drying liquid supply step, the drying liquid is dispensed from a first dispense port (3ia) of a dispenser (3) to land at a central portion of the first main surface (Wa) of the substrate (W), while the drying liquid is dispensed from a second dispense port (3ib) of the dispenser (3) to land at a peripheral edge portion of the first main surface (Wa) of the substrate (W). In the drying step, after the drying liquid supply step, the drying liquid on the first main surface (Wa) of the substrate (W) is evaporated to dry the substrate (W).

## Description

### TECHNICAL FIELD

The present disclosure relates to a substrate processing method and a substrate processing apparatus.

### BACKGROUND ART

Conventionally, a single wafer type substrate processing apparatus for processing a substrate has been disclosed (for example, Patent Document 1). In Patent Document 1, a substrate processing apparatus supplies a rinse liquid to a substrate, then supplies isopropyl alcohol having a surface tension lower than that of the rinse liquid to the substrate, and then dries the substrate. As a result, collapse of patterns of the substrate during drying is suppressed.

### PRIOR ART DOCUMENT

### PATENT DOCUMENT

Patent Document 1: Japanese Patent Application Laid-Open No. 2015-23182

### SUMMARY

### PROBLEM TO BE SOLVED BY THE INVENTION

However, with the technique of Patent Document 1, a collapse rate of the pattern of a peripheral edge portion of the substrate was still high.

Therefore, an object of the present disclosure is to provide a technique capable of reducing the collapse rate of the pattern of the peripheral edge portion of the substrate.

### MEANS TO SOLVE THE PROBLEM

A first aspect is a substrate processing method including: a holding step of holding a substrate having a first main surface on which a pattern is formed and a second main surface on a side opposite to the first main surface; a liquid processing step of supplying a processing liquid to the first main surface of the substrate; a drying liquid supply step of supplying a drying liquid having a surface tension lower than that of the processing liquid to the first main surface of the substrate while rotating the substrate and heating the second main surface of the substrate after the liquid processing step; and a drying step of drying the substrate by evaporating the drying liquid on the first main surface of the substrate after the drying liquid supply step, in which during at least a part of the drying liquid supply step, the drying liquid is dispensed from a first dispense port of a dispenser to land at a central portion of the first main surface of the substrate while the drying liquid is dispensed from a second dispense port of the dispenser to land at a peripheral edge portion of the first main surface of the substrate.

A second aspect is the substrate processing method according to the first aspect, in which in the drying step, a middle region located between the central portion and the peripheral edge portion of the first main surface of the substrate is dried before the central portion.

A third aspect is the substrate processing method according to the first or second aspect, in which in the drying liquid supply step, the drying liquid heated is dispensed from the first dispense port and the second dispense port.

A fourth aspect is the substrate processing method according to any one of the first to third aspects, in which in the drying liquid supply step, a central flow rate of the drying liquid dispensed from the first dispense port is lower than a peripheral flow rate of the drying liquid dispensed from the second dispense port during at least a latter time period of a drying liquid supply time during which the drying liquid is supplied to the first main surface of the substrate.

A fifth aspect is the substrate processing method according to any one of the first to fourth aspects, in which in the drying liquid supply step, a central flow rate of the drying liquid from the first dispense port is higher than a peripheral flow rate of the drying liquid from the second dispense port during a former time period of a drying liquid supply time during which the drying liquid is supplied to the first main surface of the substrate, and the peripheral flow rate during a latter time period after the former time period is higher than the peripheral flow rate during the former time period.

A sixth aspect is the substrate processing method according to the fifth aspect, in which the central flow rate during the latter time period is lower than the central flow rate during the former time period.

A seventh aspect is the substrate processing method according to the fifth or sixth aspect, in which the latter time period is shorter than the former time period.

An eighth aspect is the substrate processing method according to any one of the first to seventh aspects, in which in the drying liquid supply step, a heat medium is supplied to a central portion of the second main surface of the substrate to heat the substrate.

A ninth aspect is the substrate processing method according to any one of the first to eighth aspects, in which in the drying step, a heated inert gas is supplied to a central portion of the first main surface of the substrate.

A tenth aspect is the substrate processing method according to any one of the first to ninth aspects, in which in the drying liquid supply step, the second main surface of the substrate is heated so that a temperature of at least a portion of the second main surface of the substrate is equal to or higher than a boiling point of the drying liquid while the drying liquid is supplied to the first main surface of the substrate at a flow rate at which the temperature of the first main surface of the substrate is lower than the boiling point.

An eleventh aspect is the substrate processing method according to any one of the first to tenth aspects, in which in the drying liquid supply step, the second main surface of the substrate is heated only during a latter time period of a drying liquid supply time during which the drying liquid is supplied.

A twelfth aspect is a substrate processing apparatus including: a substrate holding unit that rotates a substrate having a first main surface on which a pattern is formed and a second main surface on a side opposite to the first main surface while holding the substrate; a dispenser that dispenses a processing liquid to the first main surface of the substrate held by the substrate holding unit; and a substrate heating unit that heats the second main surface of the substrate held by the substrate holding unit, in which the dispenser includes a first dispense port that dispenses a drying liquid toward a central portion of the first main surface of the substrate held by the substrate holding unit, and a second dispense port that dispenses the drying liquid toward a peripheral edge portion of the first main surface of the substrate held by the substrate holding unit.

### EFFECTS OF THE INVENTION

According to the first and twelfth aspects, the collapse rate of the pattern at the peripheral edge portion of the substrate can be reduced.

According to the second aspect, in the drying step, the middle region is dried before the central portion. For this reason, it is considered that after the middle region is dried, the processing liquid remaining in the drying liquid on a side of the central portion cannot move much to the peripheral edge portion. In other words, it is considered that the processing liquid having a low surface tension is less likely to accumulate at the peripheral edge portion. Therefore, the collapse rate of the pattern at the peripheral edge portion can be reduced.

According to the third aspect, in the drying liquid supply step, a drying liquid with a high temperature can be supplied to the first main surface of the substrate. For this reason, also in the subsequent drying step, the temperature of the drying liquid can be increased, and evaporation of the drying liquid can be further promoted while reducing the surface tension. Therefore, the collapse rate of the pattern can be further reduced.

According to the fourth aspect, the collapse rate of the pattern of the peripheral edge portion of the substrate can be further reduced.

According to the fifth aspect, during the former time period, coverage of the drying liquid on the main surface of the substrate can be improved. For this reason, adhesion of particles to the first main surface of the substrate can be suppressed. Further, since the peripheral flow rate in a subsequent step is high, the collapse rate of the pattern at the peripheral edge portion of the substrate can be reduced.

According to the sixth aspect, a total flow rate of the drying liquid can be reduced.

According to the seventh aspect, it is possible to further suppress adhesion of particles to the first main surface of the substrate.

According to the eighth aspect, the substrate can be heated with a simple configuration.

According to the ninth aspect, the heated inert gas is supplied to the central portion of the first main surface of the substrate where the drying liquid is finally evaporated. For this reason, an end point of a drying time can be effectively advanced. In other words, the drying time can be effectively shortened.

According to the tenth aspect, in the drying liquid supply step, the temperature of the first main surface of the substrate can be raised to a temperature closer to the boiling point of the drying liquid.

According to the eleventh aspect, power consumption can be reduced.

### BRIEF DESCRIPTION OF DRAWINGS

[FIG. 1] is a plan view schematically illustrating an example of a configuration of a substrate processing apparatus.
[FIG. 2] is a block diagram schematically illustrating an example of an internal configuration of a control unit.
[FIG. 3] is a longitudinal sectional view schematically illustrating an example of the configuration of a processing unit according to a first embodiment.
[FIG. 4] is a flowchart illustrating an example of an operation of the processing unit.
[FIG. 5] is a diagram schematically illustrating an example of a state of the processing unit in a drying liquid supply step.
[FIG. 6] is a diagram schematically illustrating an example of a state of the processing unit in a drying step.
[FIG. 7] is a diagram for describing an order of evaporation of a drying liquid on a first main surface of a substrate.
[FIG. 8] is a graph illustrating a collapse rate of a pattern as an experimental result.
[FIG. 9] is a diagram schematically illustrating another example of a part of the processing unit according to the first embodiment.
[FIG. 10] is a diagram illustrating an example of a timing chart of a processing unit according to a second embodiment and a temporal change in a flow rate of the drying liquid.
[FIG. 11] is a diagram schematically illustrating an example of a timing chart of a processing unit according to a third embodiment.
[FIG. 12] is a diagram schematically illustrating an example of a timing chart of a processing unit according to a fourth embodiment, and temporal changes in the flow rate of a heat medium, a temperature of the heat medium, and the temperature of the first main surface of the substrate.
[FIG. 13] is a flowchart illustrating a first example of an operation of a processing unit according to a fifth embodiment.
[FIG. 14] is a flowchart illustrating a second example of the operation of the processing unit according to the fifth embodiment.
[FIG. 15] is a diagram schematically illustrating a first example of the configuration of a processing unit according to a sixth embodiment.
[FIG. 16] is a diagram schematically illustrating a second example of the configuration of the processing unit according to the sixth embodiment.

### DESCRIPTION OF EMBODIMENTS

Hereinafter, embodiments will be described in detail with reference to the drawings. Note that, in the drawings, dimensions and the number of units are exaggerated or simplified as necessary for easy understanding. Further, portions having similar configurations and functions are denoted by the same reference numerals, and redundant description will be omitted in the following description.

Further, in the following description, similar components are illustrated with the same reference numerals, and names and functions thereof are also similar. Therefore, detailed description thereof may be omitted in order to avoid duplication.

Further, in the following description, even if ordinal numbers such as "first" or "second" are used, these terms are used for convenience to facilitate understanding of the contents of the embodiments, and are not limited to the order that can be implied by these ordinal numbers.

In a case where expressions indicating a relative or absolute positional relationship (e.g., "in one direction", "along one direction", "parallel", "orthogonal", "center", "concentric", "coaxial", etc.) are used, unless otherwise specified, the expressions shall not only strictly represent the positional relationship, but also represent a state where the position is relatively displaced relative to an angle or a distance within a range in which a tolerance or an equivalent function can be achieved. In a case where expressions indicating an equal state (for example, "same", "equal", "homogeneous", etc.) are used, unless otherwise specified, the expressions shall not only represent an equal state quantitatively and strictly, but also represent a state where a difference exists that allows for a tolerance or an equivalent function to be achieved. In a case where expressions indicating a shape (for example, "quadrangular" or "cylindrical") are used, unless otherwise specified, the expressions shall not only represent the shape geometrically and strictly, but also represent a shape having, for example, unevenness or chamfering within a range in which an equivalent effect can be achieved. In a case where expressions such as "comprise", "include", "be equipped with", "include" or "have" are used to describe one component, the expressions are not exclusive expressions that exclude the presence of other components. In a case where an expression "at least any one of A, B, and C" is used, the expression includes only A, only B, only C, any two of A, B and C, and all of A, B and C.

### <First Embodiment>

### <Overall Configuration of Substrate Processing Apparatus>

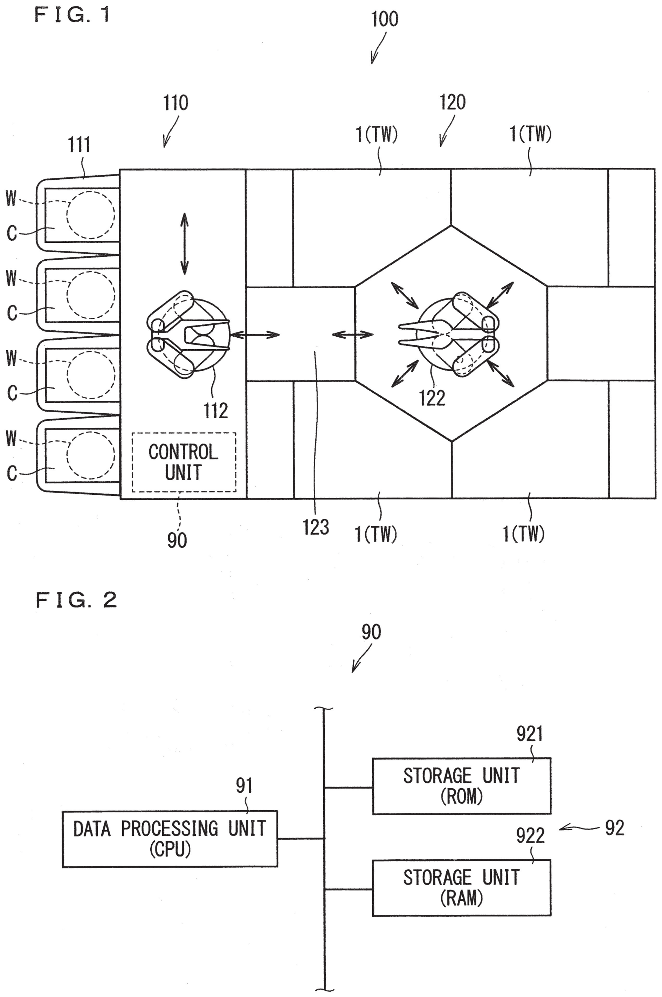

FIG. 1 is a plan view schematically illustrating an example of a configuration of a substrate processing apparatus 100. The substrate processing apparatus 100 is a single wafer type processing apparatus that processes a substrates W one by one.

The substrate W is, for example, a semiconductor wafer, a liquid crystal display substrate, an organic electroluminescence (EL) substrate, a flat panel display (FPD) substrate, an optical display substrate, a magnetic disk substrate, an optical disk substrate, a magneto-optical disk substrate, a photomask substrate, or a solar cell substrate. The substrate W has a thin flat plate shape having a first main surface Wa and a second main surface Wb. The second main surface Wb is a surface on a side opposite to the first main surface Wa. Hereinafter, it is assumed that the substrate W is a semiconductor wafer. The substrate W has, for example, a disk shape. A diameter of the substrate W is, for example, about 300 mm, and a thickness of the substrate W is, for example, about 0.5 mm or more and about 3 mm or less. A pattern is formed on the main surface of the substrate W. The pattern referred to here includes, for example, at least one of a wiring pattern, an electrode pattern, a semiconductor pattern, and an insulating pattern. An aspect ratio of the pattern is, for example, 5 or more and 500 or less. A pattern width is, for example, 3 nm or more and 50 nm or less. Such a high-aspect-ratio pattern is likely to collapse.

In the example of FIG. 1, the substrate processing apparatus 100 includes an indexer block 110, a processing block 120, and a control unit 90. The processing block 120 is a portion that mainly processes the substrate W, and the indexer block 110 is a portion that mainly transfers the substrate W between the outside of the substrate processing apparatus 100 and the processing block 120.

The indexer block 110 includes a load port 111 and a first transfer unit 112. A substrate container (hereinafter, referred to as a carrier) C carried in from the outside is placed on the load port 111. A plurality of substrates W are accommodated in the carrier C in a state of being arranged at intervals from each other in a vertical direction, for example. In the example of FIG. 1, a plurality of load ports 111 are arranged.

The first transfer unit 112 is a transfer robot, and can take out an unprocessed substrate W from the carrier C placed on each load port 111. The first transfer unit 112 may also be referred to as an indexer robot. The first transfer unit 112 transfers the unprocessed substrate W taken out from the carrier C to the processing block 120. The processing block 120 can perform processing on the unprocessed substrate W. Further, the first transfer unit 112 can receive a processed substrate W from the processing block 120 and transfer the processed substrate W to the carrier C of the load port 111.

In the example of FIG. 1, the processing block 120 includes a plurality of processing units 1 and a second transfer unit 122. The second transfer unit 122 is a transfer robot, and can transfer the substrate W between the first transfer unit 112 and the plurality of processing units 1. In the example of FIG. 1, the processing block 120 also includes a placement unit 123. The placement unit 123 is, for example, a shelf on which a plurality of substrates W can be placed in a state of being arranged in the vertical direction. The first transfer unit 112 places an unprocessed substrate W on the placement unit 123. The second transfer unit 122 takes out the unprocessed substrate W from the placement unit 123 and transfers the substrate W to the processing unit 1. The processing unit 1 processes the substrate W. The configuration of the processing unit 1 will be described later. The second transfer unit 122 takes out a processed substrate W from the processing unit 1 and transfers the substrate W to the placement unit 123. The first transfer unit 112 takes out the substrate W from the placement unit 123 and transfers the substrate W to the carrier C of the load port 111.

In the example of FIG. 1, a plurality of (for example, four) processing units 1 are provided so as to surround the second transfer unit 122 in plan view. The second transfer unit 122 may also be referred to as a center robot. The plurality of processing units 1 may be stacked in the vertical direction at each position in plan view. In other words, a plurality of (four in the drawing) towers TW composed of the plurality of processing units 1 stacked in the vertical direction may be provided so as to surround the second transfer unit 122.

The control unit 90 integrally controls the substrate processing apparatus 100. Specifically, the control unit 90 controls the first transfer unit 112, the second transfer unit 122, and the processing unit 1. FIG. 2 is a block diagram schematically illustrating an example of an internal configuration of the control unit 90. The control unit 90 is an electronic circuit, and includes, for example, a data processing unit 91 and a storage unit 92. In the specific example of FIG. 2, the data processing unit 91 and the storage unit 92 are connected to each other via a bus 93. The data processing unit 91 may be, for example, an arithmetic processing unit such as a Central Processor Unit (CPU). The storage unit 92 may include a non-transitory storage unit (for example, a read only memory (ROM)) 921 and a temporary storage unit (for example, a random access memory (RAM)) 922. The non-transitory storage unit 921 may store, for example, a program that defines processing to be executed by the control unit 90. When the data processing unit 91 executes this program, the control unit 90 can execute the processing defined in the program. Of course, a part or all of the processing to be executed by the control unit 90 may be executed by hardware such as a dedicated logic circuit.

### <Outline of Processing Unit>

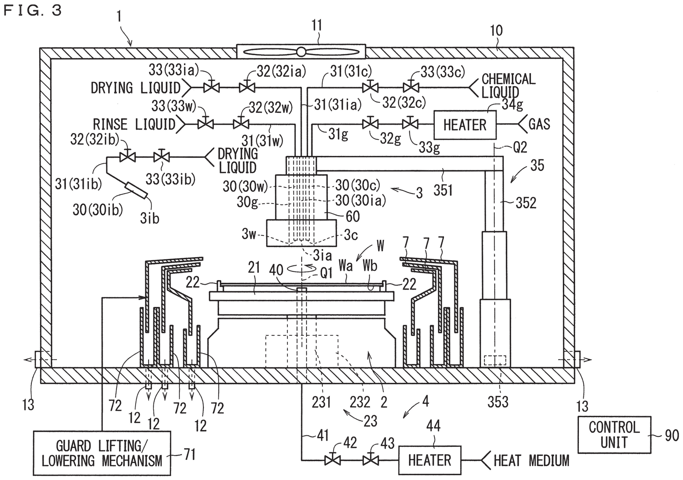

FIG. 3 is a longitudinal sectional view schematically illustrating an example of the configuration of the processing unit 1 according to the first embodiment. Note that not all the processing units 1 belonging to the substrate processing apparatus 100 need to have the configuration illustrated in FIG. 3. It is sufficient that at least one processing unit 1 of the substrate processing apparatus 100 has the configuration illustrated in FIG. 3.

The processing unit 1 includes a substrate holding unit 2, a dispenser 3, and a substrate heating unit 4.

In the example of FIG. 3, the processing unit 1 is also provided with a chamber 10. The chamber 10 has a box-like shape, and an internal space thereof corresponds to a processing space where the substrate W is processed. The chamber 10 is provided with an openable/closable transfer port (not illustrated). The second transfer unit 122 transfers an unprocessed substrate W into the chamber 10 through the transfer port, and transfers a processed substrate W out of the chamber 10 through the transfer port.

In the example of FIG. 3, a fan filter unit 11 is provided on a ceiling portion of the chamber 10. The fan filter unit 11 takes in air from outside the chamber 10, purifies it, and then blows the purified air into the chamber 10. Activation of the fan filter unit 11 creates a downflow of clean air in the chamber 10. In the example of FIG. 3, an upstream end of an exhaust pipe 13 is connected to a lower portion of a side wall of the chamber 10. A gas in the chamber 10 is discharged to the outside through the exhaust pipe 13.

The substrate holding unit 2 is provided in the chamber 10, and rotates the substrate W around a rotation axis Q1 while holding the substrate W in a horizontal orientation. The horizontal orientation referred to here is an orientation in which a thickness direction of the substrate W is along the vertical direction. The rotation axis Q1 is an axis passing through the center of the substrate W and extending along the vertical direction. Such a substrate holding unit 2 may also be referred to as a spin chuck.

Here, the first main surface Wa of the substrate W on which a pattern is formed faces vertically upward. In other words, in the example of FIG. 3, the first main surface Wa of the substrate W held by the substrate holding unit 2 corresponds to an upper surface. The pattern includes, for example, at least one of a wiring pattern, an insulating pattern, and a semiconductor pattern.

In the example of FIG. 3, the substrate holding unit 2 includes a spin base 21, a chuck pin 22, and a rotation drive unit 23. The spin base 21 has a plate-like shape (for example, a disk shape), and is provided in an orientation in which the thickness direction thereof is along the vertical direction. A plurality of chuck pins 22 are provided on the upper surface of the spin base 21. The plurality of chuck pins 22 are provided at equal intervals along a circumferential direction around the rotation axis Q1. The plurality of chuck pins 22 are provided so as to be displaceable between a holding position and a release position to be described below. The holding position is a position where the chuck pin 22 abuts on a peripheral edge of the substrate W. When the plurality of chuck pins 22 stop at the respective holding positions, the plurality of chuck pins 22 hold the substrate W. FIG. 3 illustrates the chuck pin 22 stopped at the holding position. The release position is a position where each chuck pin 22 is separated from the substrate W. When the plurality of chuck pins 22 stop at the respective release positions, holding of the substrate W by the plurality of chuck pins 22 is released. The substrate holding unit 2 also includes a pin drive unit (not illustrated) that displaces the chuck pins 22. The pin drive unit includes, for example, a drive source such as a motor and an air cylinder, and is controlled by the control unit 90.

The rotation drive unit 23 includes a shaft 231 and a motor 232. An upper end of the shaft 231 is connected to a lower surface of the spin base 21, and the shaft 231 extends from the lower surface of the spin base 21 along the rotation axis Q1. The motor 232 is controlled by the control unit 90 to rotate the shaft 231 around the rotation axis Q1. As a result, the spin base 21, the chuck pin 22, and the substrate W rotate integrally around the rotation axis Q1.

Note that the substrate holding unit 2 does not necessarily need to have the chuck pins 22. For example, the substrate holding unit 2 may hold the substrate W by a chuck method such as a vacuum chuck, an electrostatic chuck, or a Bernoulli chuck.

The dispenser 3 dispenses a processing liquid toward the first main surface Wa of the substrate W held by the substrate holding unit 2. As illustrated in FIG. 3, the dispenser 3 includes at least one nozzle 30. The nozzle 30 dispenses the processing liquid toward the first main surface Wa of the substrate W held by the substrate holding unit 2. Here, since the first main surface Wa corresponds to the upper surface of the substrate W, the nozzle 30 is provided vertically above the substrate W held by the substrate holding unit 2. The nozzle 30 is, for example, a straight nozzle that dispenses the processing liquid in a continuous flow state.

In the example of FIG. 3, as the nozzle 30, a nozzle 30c, a nozzle 30w, a nozzle 30ia, and a nozzle 30ib are illustrated. In the example of FIG. 3, the nozzle 30c, the nozzle 30w, and the nozzle 30ia extend along the vertical direction. In the example of FIG. 3, a dispense port 3c is formed on the lower surface of the nozzle 30c, a dispense port 3w is formed on the lower surface of the nozzle 30w, and a dispense port 3ia (corresponding to a first dispense port) is formed on the lower surface of the nozzle 30ia. The nozzle 30c dispenses a chemical liquid from the dispense port 3c, the nozzle 30w dispenses a rinse liquid from the dispense port 3w, and the nozzle 30ia dispenses a drying liquid from the dispense port 3ia. The chemical liquid, the rinse liquid, and the drying liquid are all examples of the processing liquid, and specific examples thereof will be described later.

The nozzle 30c, the nozzle 30w, and the nozzle 30ia dispense the processing liquid toward the central portion of the first main surface Wa of the substrate W held by the substrate holding unit 2. In the example of FIG. 3, the nozzle 30c, the nozzle 30w, and the nozzle 30ia are adjacent to each other in a horizontal direction and are fixed to each other. In the example of FIG. 3, the nozzle 30c, the nozzle 30w, and the nozzle 30ia are provided inside an opposing member 60. The opposing member 60 has, for example, a cylindrical shape. The opposing member 60 has a hollow shape, and a lower end port of the hollow portion is opened on the lower surface of the opposing member 60. The nozzle 30c, the nozzle 30w, and the nozzle 30ia are provided in the hollow portion of the opposing member 60, and the processing liquid dispensed from each nozzle 30 flows out from the lower end port of the opposing member 60. In the example of FIG. 3, the opposing member 60 is provided at a position facing the central portion of the substrate W held by the substrate holding unit 2 in the vertical direction.

The nozzle 30ib has a dispense port 3ib (corresponding to a second dispense port), and dispenses the drying liquid from the dispense port 3ib toward the peripheral edge portion of the first main surface Wa of the substrate W held by the substrate holding unit 2. For this reason, a liquid landing position of the drying liquid dispensed from the nozzle 30ib on the first main surface Wa (hereinafter, referred to as a peripheral liquid landing position) is closer to the peripheral edge of the substrate W than a liquid landing position of the drying liquid dispensed from the nozzle 30ia on the first main surface Wa (hereinafter, referred to as a central liquid landing position). The peripheral liquid landing position may be, for example, within a virtual annular region to be described below. A virtual center of the annular region coincides with the rotation axis Q1. A virtual outer diameter of the annular region may be, for example, 90%, 80%, or 70% of the diameter of the substrate W. A virtual inner diameter of the annular region may be, for example, 10%, 20%, 30%, or 40% of the diameter of the substrate W.

In the example of FIG. 3, the nozzle 30ib is provided radially outward from the peripheral edge of the substrate W held by the substrate holding unit 2. The nozzle 30ib dispenses the drying liquid toward the side of the rotation axis Q1 and in an oblique direction vertically downward. In this case, the drying liquid that is dispensed from the nozzle 30ib and has landed on the first main surface Wa of the substrate W can temporarily flow toward the side of the rotation axis Q1 (that is, radially inward). Then, the drying liquid receives a centrifugal force accompanying rotation of the substrate W and flows radially outward.

Focusing on the function of dispensing the drying liquid, it can be said that the dispenser 3 has a dispense port 3ia that dispenses the drying liquid toward the central portion of the first main surface Wa of the substrate W and a dispense port 3ib that dispenses the drying liquid toward the peripheral edge portion of the first main surface Wa of the substrate W.

The nozzle 30 is connected to a downstream end of a supply pipe 31, and the upstream end of the supply pipe 31 is connected to a processing liquid supply source. In the example of FIG. 3, as the supply pipe 31, a supply pipe 31c, a supply pipe 31w, a supply pipe 31ia, and a supply pipe 31ib are illustrated.

The downstream end of the supply pipe 31c is connected to the nozzle 30c, and the upstream end of the supply pipe 31c is connected to a chemical liquid supply source. The chemical liquid supply source includes a tank (not illustrated) that stores a chemical liquid, and supplies the chemical liquid to the upstream end of the supply pipe 31c. As the chemical liquid, for example, liquids such as fluoronitric acid obtained by mixing hydrofluoric acid, nitric acid, and water, hydrofluoric acid hydrogen peroxide aqueous solution (FPM) obtained by mixing hydrofluoric acid, hydrogen peroxide, and water, tetramethylammonium hydroxide (TMAH), a mixture (SPM) of sulfuric acid and hydrogen peroxide water, ammonia water, a mixture (SC-1) of ammonia, hydrogen peroxide, and water, and a mixture (SC-2) of hydrogen chloride, hydrogen peroxide, and water can be applied. Note that the chemical liquid may be a single liquid instead of a mixture. For example, a single liquid such as hydrofluoric acid (HF), hydrogen peroxide water, and sulfuric acid can be applied as the chemical liquid.

The downstream end of the supply pipe 31w is connected to the nozzle 30w, and the upstream end of the supply pipe 31w is connected to a rinse liquid supply source. The rinse liquid supply source includes a tank (not illustrated) that stores a rinse liquid, and supplies the rinse liquid to the upstream end of the supply pipe 31w. As the rinse liquid, for example, pure water, carbon dioxide water, or ozone water can be applied.

The downstream end of the supply pipe 31ia is connected to the nozzle 30ia, and the upstream end of the supply pipe 31ia is connected to a drying liquid supply source. The downstream end of the supply pipe 31ib is connected to the nozzle 30ib, and the upstream end of the supply pipe 311ib is connected to the drying liquid supply source. The drying liquid supply source has a tank (not illustrated) that stores a drying liquid, and supplies the drying liquid to the upstream ends of the supply pipe 31ia and the supply pipe 31ib. As the drying liquid, for example, an organic solvent such as isopropyl alcohol can be applied. The surface tension of the drying liquid is lower than the surface tension of other processing liquids (for example, both the surface tension of the chemical liquid and the surface tension of the rinse liquid). Further, volatility of the drying liquid is higher than the volatility of other processing liquids (for example, both the volatility of the chemical liquid and the volatility of the rinse liquid).

A supply valve 32 and a flow rate control valve 33 are interposed in the supply pipe 31. In the example of FIG. 3, a supply valve 32c and a flow rate control valve 33c are interposed in the supply pipe 31c, a supply valve 32w and a flow rate control valve 33w are interposed in the supply pipe 31w, a supply valve 32ia and a flow rate control valve 33ia are interposed in the supply pipe 31ia, and a supply valve 32ib and a flow rate control valve 33ib are interposed in the supply pipe 31ib. The supply valve 32 switches opening and closing of the supply pipe 31. The flow rate control valve 33 adjusts the flow rate of the processing liquid flowing through the supply pipe 31. The flow rate control valve 33 may be a mass flow controller. The supply valve 32 and the flow rate control valve 33 are controlled by the control unit 90.

The dispenser 3 dispenses various processing liquids toward the first main surface Wa of the substrate W in the order to be described later. As a result, the processing unit 1 can sequentially perform various processing on the first main surface Wa of the substrate W according to the type of processing liquid. Specific processing will be described later.

In the example of FIG. 3, the opposing member 60 is configured to be capable of dispensing a gas toward the first main surface Wa of the substrate W held by the substrate holding unit 2. In the example of FIG. 3, a space other than the nozzle 30 in the hollow portion of the opposing member 60 functions as a gas flow path 30g. The lower end port of the lower surface of the opposing member 60 corresponds to a dispense port of the gas flow path 30g.

In the example of FIG. 3, an upper portion of the opposing member 60 is connected to the downstream end of a supply pipe 31g. In other words, the downstream end of the supply pipe 31g is connected to the gas flow path 30g. The upstream end of the supply pipe 31g is connected to a gas supply source. The gas supply source includes a storage unit (not illustrated) that stores an inert gas, and supplies the inert gas to the upstream end of the supply pipe 31g. The inert gas includes, for example, at least one of nitrogen gas and a rare gas. The rare gas includes, for example, argon gas.

The supply pipe 31g is provided with a supply valve 32g, a flow rate control valve 33g, and a heater 34g. The supply valve 32g switches opening and closing of the supply pipe 31g. The flow rate control valve 33g adjusts the flow rate of the inert gas flowing through the supply pipe 31g. The heater 34g heats the inert gas flowing through the supply pipe 31g. The heater 34g may be, for example, an electric resistance type heater having an electric heating wire. The supply valve 32g, the flow rate control valve 33g, and the heater 34g are controlled by the control unit 90.

When the supply valve 32g is opened and the heater 34g is activated, a high-temperature inert gas is dispensed from the central portion of the lower surface of the opposing member 60 (that is, the lower end port of the gas flow path 30g) toward the central portion of the first main surface Wa of the substrate W. As a result, drying of the substrate W can be promoted.

In the example of FIG. 3, the processing unit 1 is provided with a movement drive unit 35. The movement drive unit 35 integrally moves a dispense head including the nozzle 30c, the nozzle 30w, the nozzle 30ia, and the opposing member 60. Specifically, the movement drive unit 35 moves the dispense head between a processing position and a standby position to be described below. The processing position is a position where the nozzle 30c, the nozzle 30w, and the nozzle 30ia dispense the processing liquid toward the first main surface Wa of the substrate W, and is, for example, a position facing the central portion of the first main surface Wa of the substrate W in the vertical direction. The processing position is also a position where the opposing member 60 dispenses the inert gas toward the first main surface Wa of the substrate W. In the example of FIG. 3, the dispense head stopped at the processing position is illustrated. The standby position is a position where the nozzle 30c, the nozzle 30w, and the nozzle 30ia do not dispense the processing liquid toward the first main surface Wa of the substrate W, and is, for example, a position radially outward from the substrate holding unit 2. The standby position is also a position where the opposing member 60 does not dispense the inert gas toward the first main surface Wa of the substrate W.

FIG. 3 illustrates an example of a specific configuration of the movement drive unit 35. In the example of FIG. 3, the movement drive unit 35 includes an arm 351, a support column 352, and a drive source 353. The support column 352 is provided radially outward from a guard 7 to be described later, and extends along the vertical direction. The arm 351 extends along the horizontal direction, and has a distal end connected to the dispense head and a proximal end connected to the support column 352. The drive source 353 is controlled by the control unit 90, and rotates the support column 352 in forward and reverse directions within a predetermined angular range around the central axis Q2 thereof. The drive source 353 includes, for example, a motor. When the support column 352 rotates in forward and reverse directions within a predetermined angular range around the central axis Q2, the dispense head reciprocates along the circumferential direction around the central axis Q2. The support column 352 is installed such that the processing position and the standby position are located on a movement trajectory of the dispense head. Note that the movement drive unit 35 is not necessarily limited to the configuration shown in FIG. 3, and may include a linear motion mechanism such as a linear motor, for example.

The substrate heating unit 4 heats the second main surface Wb of the substrate W held by the substrate holding unit 2. In the example of FIG. 3, the substrate heating unit 4 is provided at a position facing the second main surface Wb of the substrate W in the vertical direction. In the example of FIG. 3, since the second main surface Wb of the substrate W corresponds to the lower surface, the substrate heating unit 4 is provided directly below the substrate W.

In the example of FIG. 3, the substrate heating unit 4 includes a nozzle 40. The nozzle 40 dispenses a heat medium toward the second main surface Wb of the substrate W. In the example of FIG. 3, since the second main surface Wb of the substrate W corresponds to the lower surface, the nozzle 40 may also be referred to as a lower surface nozzle. In the example of FIG. 3, a through hole is formed in the central portion of the spin base 21 of the substrate holding unit 2, and the shaft 231 is a hollow shaft. The through hole of the spin base 21 and the hollow portion of the shaft 231 are connected in the vertical direction. A part of the nozzle 40 is disposed in the through hole. A dispense port is formed on the upper surface of the nozzle 40, and the dispense port of the nozzle 40 faces the central portion of the second main surface Wb of the substrate W in the vertical direction. The nozzle 40 dispenses the heat medium toward the central portion of the second main surface Wb of the substrate W.

The downstream end of a supply pipe 41 is connected to the nozzle 40. The supply pipe 41 extends inside the shaft 231 and passes through the shaft 231. The upstream end of the supply pipe 41 is connected to a heat medium supply source. The heat medium is a fluid (gas or liquid), and is a liquid such as water as a more specific example. The heat medium supply source includes, for example, a tank (not illustrated) that stores a heat medium, and supplies the heat medium to the upstream end of the supply pipe 41.

In the example of FIG. 3, the supply pipe 41 is provided with a supply valve 42, a flow rate control valve 43, and a heater 44. The supply valve 42 switches opening and closing of the supply pipe 41. The flow rate control valve 43 adjusts the flow rate of the heat medium flowing through the supply pipe 41. The flow rate control valve 43 may be a mass flow controller. The heater 44 heats the heat medium flowing through the supply pipe 41. The heater 44 may be, for example, an electric resistance type heater having an electric heating wire. The supply valve 42, the flow rate control valve 43, and the heater 44 are controlled by the control unit 90.

When the supply valve 42 is opened and the heater 44 is activated, a high-temperature heat medium is dispensed from the nozzle 40 to the central portion of the second main surface Wb of the substrate W. The heat medium that has landed at the central portion of the second main surface Wb of the substrate W receives a centrifugal force accompanying the rotation of the substrate W, flows radially outward along the second main surface Wb, and scatters outward from the peripheral edge of the substrate W. When the high-temperature heat medium flows along the second main surface Wb of the substrate W, heat is transferred from the heat medium to the substrate W, thereby heating the substrate W.

In the example of FIG. 3, the processing unit 1 is provided with a guard 7 and a guard lifting/lowering drive unit 71. The guard 7 has a tubular shape with the rotation axis Q1 as a central axis, and surrounds the substrate holding unit 2. The guard 7 can catch the processing liquid and the heat medium scattered from the peripheral edge of the substrate W. The guard 7 is lifted and lowered by the guard lifting/lowering drive unit 71 between an upper position and a lower position to be described below. The upper position is a position where the upper end of the guard 7 is vertically above the substrate W held by the substrate holding unit 2. The guard 7 can catch the processing liquid and the heat medium scattered from the peripheral edge of the substrate W in a state of being located at the upper position. The lower position is a position lower than the upper position, and is, for example, a position where the upper end of the guard 7 is vertically below the upper surface of the spin base 21.

In the example of FIG. 3, a plurality of guards 7 are provided. The plurality of guards 7 are arranged concentrically. The plurality of guards 7 may be selectively used according to the type of processing liquid. In the example of FIG. 3, a cup 72 corresponding to each guard 7 is provided. The cup 72 has an annular (for example, circular) recess (groove) surrounding the rotation axis Q1. Each cup 72 catches the processing liquid flowing down on an inner peripheral surface of the corresponding guard 7. The upstream end of a discharge pipe 12 is connected to, for example, a bottom of each cup 72. The processing liquid caught by each cup 72 is discharged to the outside of the processing unit 1 through the discharge pipe 12.

### <Example of Operation of Substrate Processing Apparatus>

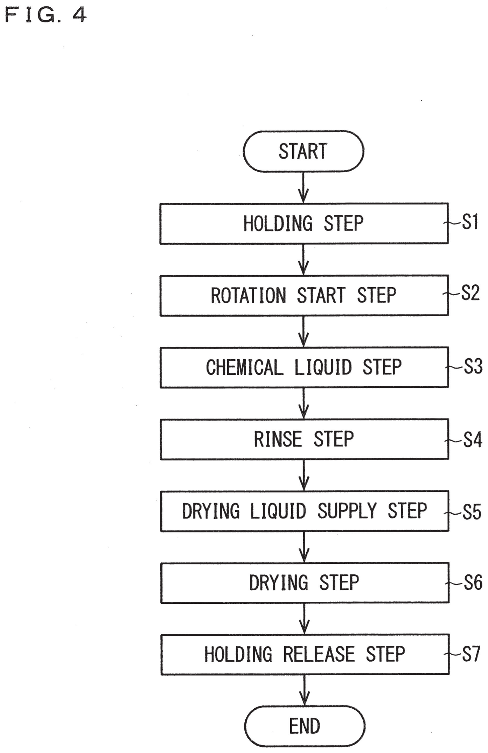

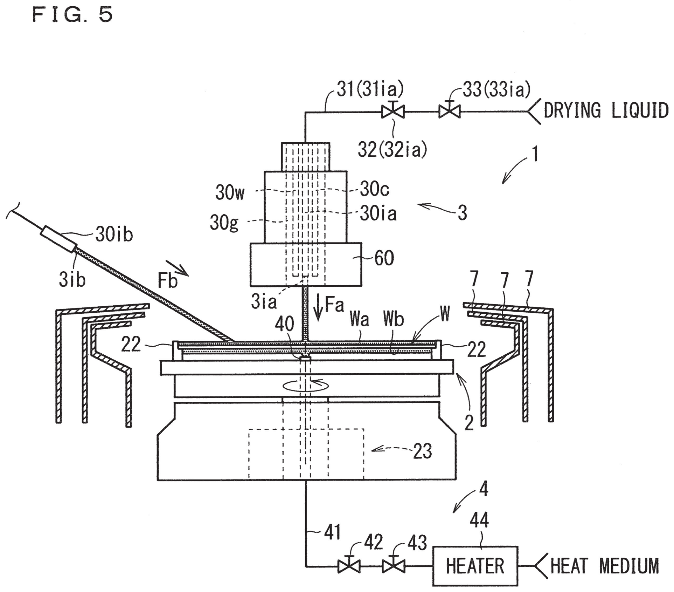

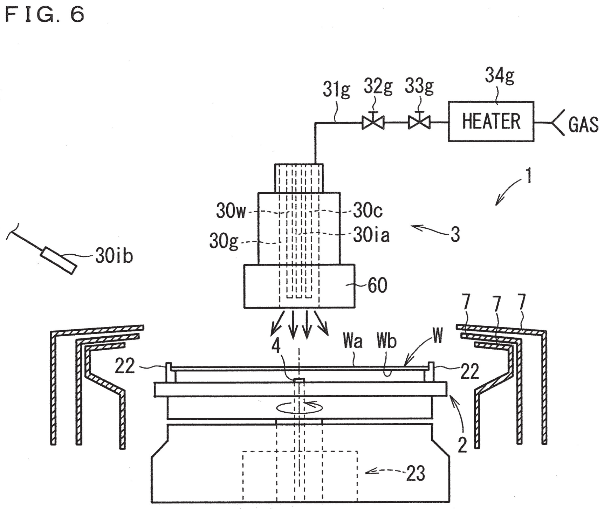

Next, an example of the operation of the processing unit 1 will be described. FIG. 4 is a flowchart illustrating an example of the operation of the processing unit 1. The control unit 90 causes the processing unit 1 to execute the processing of steps S1 to S7 in accordance with a preset processing procedure (recipe). FIG. 5 is a view schematically illustrating an example of a state of the processing unit 1 in a drying liquid supply step to be described later, and FIG. 6 is a view schematically illustrating an example of a state of the processing unit 1 in a drying step to be described later.

First, the second transfer unit 122 transfers the substrate W to the processing unit 1. Then, the substrate holding unit 2 holds the substrate W received from the second transfer unit 122 (step S1: holding step). As a specific example, the substrate holding unit 2 displaces the plurality of chuck pins 22 from the respective release positions to the holding positions. As a result, the plurality of chuck pins 22 hold the substrate W. The substrate holding unit 2 continues to hold the substrate W until the processing on the substrate W is completed.

Next, the substrate holding unit 2 starts rotation of the substrate W (step S2: rotation start step). The substrate holding unit 2 may continue rotating the substrate W until the processing of the substrate W is completed.

Next, the processing unit 1 supplies a chemical liquid to the first main surface Wa of the substrate W (step S3: chemical liquid step). First, the movement drive unit 35 moves the dispense head to the processing position. Further, the guard lifting/lowering drive unit 71 lifts the guard 7 for the chemical liquid to the upper position. Then, the control unit 90 opens the supply valve 32c. In other words, the control unit 90 switches the supply valve 32c from a closed state to an open state. As a result, the chemical liquid is dispensed from the nozzle 30c toward the first main surface Wa of the rotating substrate W. The chemical liquid that has landed on the first main surface Wa of the substrate W flows radially outward by receiving a centrifugal force accompanying the rotation of the substrate W and scatters from the peripheral edge of the substrate W. At this time, the chemical liquid acts on the first main surface Wa of the substrate W, so that the chemical liquid processing corresponding to the type of chemical liquid is performed on the first main surface Wa of the substrate W. For example, the processing unit 1 performs a cleaning processing of cleaning and removing impurities on the first main surface Wa of the substrate W or an etching processing of etching a predetermined film of the first main surface Wa of the substrate W. The chemical liquid scattered from the peripheral edge of the substrate W is caught by the guard 7 and discharged to the outside of the chamber 10 through the discharge pipe 12.

When the processing on the substrate W is sufficiently performed, the control unit 90 closes the supply valve 32c. As a specific example, the control unit 90 measures an elapsed time from the start of dispense of the chemical liquid, and determines whether or not the elapsed time is equal to or longer than a predetermined chemical liquid time. The chemical liquid time is set in advance to a time period during which the chemical liquid processing is sufficiently performed. The elapsed time is measured by, for example, a timer circuit (not illustrated) belonging to the control unit 90. The control unit 90 switches the supply valve 32c from the open state to the closed state when the elapsed time is equal to or longer than the chemical liquid time.

Next, the processing unit 1 supplies a rinse liquid to the first main surface Wa of the substrate W (step S4: rinse step). In a case where the guard 7 for the rinse liquid is different from the guard 7 for the chemical liquid, the guard lifting/lowering drive unit 71 appropriately lifts and lowers the guard 7 to position the guard 7 for the rinse liquid at the upper position. Then, the control unit 90 opens the supply valve 32w. In other words, the control unit 90 switches the supply valve 32w from the closed state to the open state. As a result, the rinse liquid is dispensed from the nozzle 30w toward the first main surface Wa of the rotating substrate W. The rinse liquid that has landed on the first main surface Wa of the substrate W flows radially outward by receiving a centrifugal force accompanying the rotation of the substrate W and scatters from the peripheral edge of the substrate W. At this time, the rinse liquid pushes the chemical liquid on the first main surface Wa of the substrate W radially outward. As a result, the processing liquid on the first main surface Wa of the substrate W is replaced from the chemical liquid to the rinse liquid. The processing liquid scattered from the peripheral edge of the substrate W is caught by the guard 7 and discharged to the outside of the chamber 10 through the discharge pipe 12.

When replacement from the chemical liquid to the rinse liquid is sufficiently performed, the control unit 90 closes the supply valve 32w. As a specific example, the control unit 90 measures an elapsed time from the start of dispense of the rinse liquid, and switches the supply valve 32w from the open state to the closed state when the elapsed time becomes equal to or longer than a predetermined rinse time. The rinse time is set in advance to a time period during which the replacement from the chemical liquid to the rinse liquid is sufficiently performed.

Next, the processing unit 1 supplies a drying liquid to the first main surface Wa of the substrate W (step S5: drying liquid supply step). In a case where the guard 7 for the drying liquid is different from the guard 7 for the rinse liquid, the guard lifting/lowering drive unit 71 appropriately lifts and lowers the guard 7 to lift the guard 7 for the drying liquid to the upper position. Then, the control unit 90 opens the supply valve 32ia and the supply valve 32ib. In other words, the control unit 90 switches the supply valve 32ia and the supply valve 32ib from the closed state to the open state.

When the supply valve 32ia and the supply valve 32ib are opened, as illustrated in FIG. 5, the drying liquid is dispensed from the dispense port 3ia of the nozzle 30ia and the dispense port 3ib of the nozzle 30ib toward the first main surface Wa of the rotating substrate W. The temperature of the drying liquid may be, for example, normal temperature (for example, about 25 degrees Celsius). The temperature of the drying liquid referred to here is, for example, the temperature of the drying liquid at each of the dispense port 3ia and the dispense port 3ib. Further, the normal temperature referred to here includes, for example, the temperature of the drying liquid when a heater for heating the drying liquid is not provided upstream of the dispense port 3ia and the dispense port 3ib or when the heater is not operating. In other words, the normal temperature includes the temperature of the drying liquid that is not heated.

The drying liquid from the nozzle 30ia lands on the central portion of the first main surface Wa of the substrate W, and the drying liquid from the nozzle 30ib lands on the peripheral edge portion of the first main surface Wa of the substrate W. The drying liquid that has landed on the first main surface Wa flows radially outward by receiving a centrifugal force accompanying the rotation of the substrate W and scatters from the peripheral edge of the substrate W. At this time, the drying liquid pushes the rinse liquid on the first main surface Wa of the substrate W, so that the processing liquid on the first main surface Wa of the substrate W is replaced from the rinse liquid to the drying liquid. The processing liquid scattered from the peripheral edge of the substrate W is caught by the guard 7 and discharged to the outside of the chamber 10 through the discharge pipe 12.

The total flow rate of the drying liquid dispensed from the nozzle 30ia and the nozzle 30ib may be set to, for example, 100 mL (milliliter)/min or more, and as a specific example, may be set to, for example, 250 mL/min. A rotation speed of the substrate W in the drying liquid supply step may be set to, for example, 150 rpm or more and 600 rpm or less, or may be set to 200 rpm or more and 400 rpm or less. As a more specific example, the rotation speed may be set to 300 rpm.

Further, the processing unit 1 heats the second main surface Wb of the substrate W when the drying liquid is supplied. In other words, the substrate heating unit 4 heats the second main surface Wb of the substrate W. As a more specific example, the control unit 90 opens the supply valve 42 and activates the heater 44. According to this, as illustrated in FIG. 5, a high-temperature heat medium (for example, hot water) is dispensed from the nozzle 40 toward the central portion of the second main surface Wb of the rotating substrate W. The heat medium that has landed at the central portion of the second main surface Wb of the substrate W flows radially outward by receiving a centrifugal force accompanying the rotation of the substrate W and scatters from the peripheral edge of the substrate W. When the high-temperature heat medium flows along the second main surface Wb of the substrate W, heat is transferred from the heat medium to the substrate W, thereby heating the substrate W. The heat of the substrate W is transferred to the drying liquid on the first main surface Wa. For this reason, the drying liquid on the first main surface Wa of the substrate W is also heated and the temperature rises.

The heater 44 may heat the heat medium to, for example, 60 degrees Celsius or higher, 70 degrees Celsius or higher, or 80 degrees Celsius or higher. Further, the heater 44 may adjust the temperature of the heat medium to, for example, lower than the boiling point of the drying liquid. The temperature of the heat medium referred to here is, for example, the temperature of the heat medium at the dispense port of the nozzle 40. The flow rate control valve 43 may adjust the flow rate of the heat medium to, for example, a value greater than the flow rate of the drying liquid. More specifically, the flow rate control valve 43 may adjust the flow rate of the heat medium to 1000 mL/min or more, or 1500 mL/min or more.

As described above, in the drying liquid supply step, the processing unit 1 supplies the drying liquid to the first main surface Wa of the substrate W while rotating the substrate W and heating the second main surface Wb of the substrate W. Moreover, the processing unit 1 dispenses the drying liquid from the dispense port 3ia and the dispense port 3ib to cause the drying liquid to land at the central liquid landing position and the peripheral liquid landing position of the first main surface Wa of the substrate W.

When the replacement from the rinse liquid to the drying liquid is sufficiently performed, the processing unit 1 dries the substrate W (step S6: drying step). Specifically, the processing unit 1 measures an elapsed time from the start of dispense of the drying liquid, and determines whether or not the elapsed time is equal to or longer than a predetermined drying liquid supply time. The drying liquid supply time is set in advance to a time period during which the replacement from the rinse liquid to the drying liquid is sufficiently performed. The drying liquid supply time is set to, for example, about several tens of seconds or more, and can be set to about 40 seconds as a specific example. Then, when the elapsed time is equal to or longer than the drying liquid supply time, the processing unit 1 dries the substrate W. Specifically, the control unit 90 closes the supply valve 32ia and the supply valve 32ib. The control unit 90 may switch the supply valve 32ia and the supply valve 32ib from the open state to the closed state substantially simultaneously. The term "substantially simultaneously" referred to here includes, for example, a time difference of 1 second or less. Further, the substrate heating unit 4 stops heating the second main surface Wb of the substrate W. Specifically, the control unit 90 closes the supply valve 42. A timing of closing the supply valve 42 may be substantially the same as the timing of closing the supply valve 32ia and the supply valve 32ib.

Furthermore, the control unit 90 causes the substrate holding unit 2 to increase the rotation speed of the substrate W. For example, the substrate holding unit 2 may rotate the substrate W at a rotation speed of, for example, 800 rpm or more and 2500 rpm or less, or may rotate the substrate W at a rotation speed of 800 rpm or more and 1500 rpm or less. Further, the substrate holding unit 2 may gradually (for example, stepwise) increase the rotation speed of the substrate W. The timing to start increasing the rotation speed of the substrate W may be substantially the same as the timing to close the supply valve 32ia and the supply valve 32ib.

The processing unit 1 may supply an inert gas toward the central portion of the first main surface Wa of the substrate W. Specifically, the control unit 90 may open the supply valve 32g and activate the heater 34g. As a result, as illustrated in FIG. 6, a high-temperature inert gas is dispensed from a gas dispense port (that is, the lower end port of the gas flow path 30g) in the central portion of the lower surface of the opposing member 60 toward the central portion of the first main surface Wa of the substrate W. In FIG. 6, the direction in which the inert gas flows is schematically indicated by an arrow directly below the opposing member 60. The inert gas hitting the central portion of the first main surface Wa of the substrate W flows radially outward along the first main surface Wa. The heater 34g may heat the inert gas to, for example, 60 degrees Celsius or higher, 70 degrees Celsius or higher, or 80 degrees Celsius or higher. The temperature of the inert gas may be, for example, the temperature of the inert gas at the gas dispense port of the gas flow path 30g. The flow rate control valve 33g may adjust the flow rate of the inert gas to, for example, 10 L (liter)/min or more and 300 L/min or less.

When the drying liquid is sufficiently evaporated, the processing unit 1 stops the rotation of the substrate W while stopping the dispense of the inert gas. As a specific example, the control unit 90 measures an elapsed time from the stop of the dispense of the drying liquid, and determines whether or not the measured time is equal to or longer than a predetermined drying time. The drying time is set in advance to a time period during which the substrate W is sufficiently dried. When the elapsed time is equal to or longer than the drying time, the control unit 90 switches the supply valve 32g from the open state to the closed state, and causes the substrate holding unit 2 to stop the rotation of the substrate W. Further, the movement drive unit 35 moves the dispense head to the standby position, and the guard lifting/lowering drive unit 71 lowers the guard 7 to the lower position.

Next, the substrate holding unit 2 releases the holding on the substrate W (step S7: holding release step). Then, the second transfer unit 122 takes out the processed substrate W from the processing unit 1.

As described above, the processing unit 1 can perform processing on the substrate W. Moreover, in the present embodiment, in the drying liquid supply step after the liquid processing step including the chemical liquid step and the rinsing step, the dispenser 3 dispenses the drying liquid toward the central liquid landing position and the peripheral liquid landing position of the first main surface Wa of the substrate W, respectively (see FIG. 5). In the example described above, the nozzle 30ia dispenses the drying liquid toward the central liquid landing position, and the nozzle 30ib dispenses the drying liquid toward the peripheral liquid landing position. For this reason, the drying liquid lands at each of the central liquid landing position and the peripheral liquid landing position of the first main surface Wa of the substrate W.

Moreover, in the present embodiment, in the drying liquid supply step, the substrate heating unit 4 heats the second main surface Wb of the substrate W. In the example described above, the nozzle 40 dispenses a high-temperature heat medium toward the central portion of the second main surface Wb of the substrate W. For this reason, the substrate W and the drying liquid on the first main surface Wa of the substrate W are heated by the heat medium.

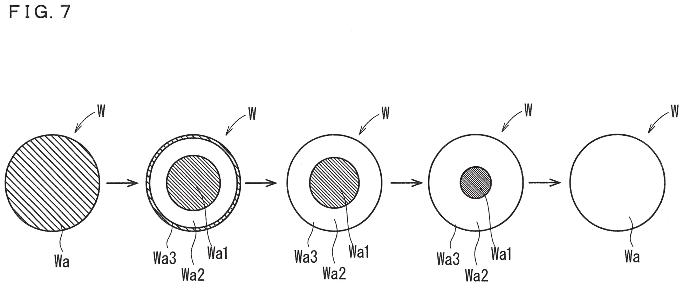

By performing such a drying liquid supply step, in the subsequent drying step, the drying liquid on the first main surface Wa of the substrate W can be evaporated in the order to be described below. FIG. 7 is a diagram for explaining the order of evaporation of the drying liquid on the first main surface Wa of the substrate W. In FIG. 7, the first main surface Wa of the substrate W is schematically illustrated in chronological order. In FIG. 7, the region of the first main surface Wa of the substrate W where the drying liquid exists is indicated by diagonal hatching. As illustrated in FIG. 7, initially, the drying liquid exists on an entire surface of the first main surface Wa of the substrate W. As time passes, the drying liquid on a middle region Wa2 of the first main surface Wa of the substrate W first evaporates to expose (alternatively, dry, the same applies below) the middle region Wa2. The middle region Wa2 is a region concentric with the substrate W and having an annular shape, and is a region located between the central portion and the peripheral edge portion of the substrate W. Then, the dried region expands radially as time passes, exposing a peripheral edge region Wa3 of the first main surface Wa. The peripheral edge region Wa3 is an annular region that is radially outward from the middle region Wa2 and concentric with the substrate W. Finally, a central region Wa1 of the first main surface Wa is exposed.

Note that, the inventor has confirmed that the evaporation order described above occurs at least above the pattern of the first main surface Wa of the substrate W. In view of the fact that evaporation mainly occurs from the upper surface of the drying liquid, it is considered that the drying liquid evaporates in the evaporation order described above also inside the pattern.

The reason why the drying liquid evaporates in such an evaporation order is not necessarily clear, but one possible reason is as follows. In other words, in the drying liquid supply step, it is considered that a film thickness of the drying liquid on the first main surface Wa of the substrate W becomes thinner on the middle region Wa2 as the drying liquid lands not only at the central liquid landing position but also at the peripheral liquid landing position. Moreover, in the drying liquid supply step, since the drying liquid on the first main surface Wa of the substrate W is heated, the drying liquid is in a state where it easily evaporates. For this reason, in the drying step, it is considered that the evaporation of the drying liquid on the middle region Wa2 is completed prior to the other regions, and the middle region Wa2 is first exposed by a high-speed rotation of the substrate W.

As described above, in the present embodiment, in the drying liquid supply step, the second main surface Wb of the substrate W is heated while the drying liquid is caused to land at the central liquid landing position and the peripheral liquid landing position, whereby the evaporation of the drying liquid can be completed in the order of the middle region Wa2, the peripheral edge region Wa3, and the central region Wa1 in the drying step. in other words, the middle region Wa2 is dried before the central region Wa1.

For comparison, a case where the drying liquid is caused to land only at the central liquid landing position in the drying liquid supply step will be described. In this case, in the drying step, the central region Wa1 of the first main surface Wa is first exposed, and the dried region spreads radially outward over time. In other words, as in a comparative example, in a case where the flow rate of the drying liquid landing at the peripheral liquid landing position is zero, the first main surface Wa is exposed starting from the central region Wa1.

Conversely, in the present embodiment, the flow rate of the drying liquid landing at the central liquid landing position (hereinafter, referred to as a central flow rate Fa) and the flow rate of the drying liquid landing at the peripheral liquid landing position (hereinafter, referred to as a peripheral flow rate Fb) in the drying liquid supply step can be set such that the middle region Wa2 is exposed before the central region Wa1 in the drying step. More specifically, in the drying step, the central flow rate Fa and the peripheral flow rate Fb can be set such that the first main surface Wa is exposed in the order of the middle region Wa2, the peripheral edge region Wa3, and the central region Wa1.

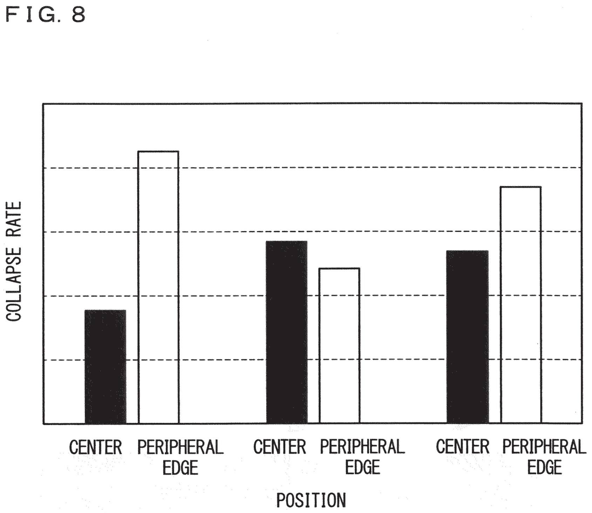

Next, the collapse rate of a pattern will be described. FIG. 8 is a graph illustrating the collapse rate of a pattern as an experimental result. FIG. 8 illustrates the collapse rate according to the comparative example and the collapse rate according to the present embodiment. Two bar graphs on a left side of FIG. 8 show the collapse rate according to the comparative example, and two bar graphs on the center and two bar graphs on a right side show the collapse rate according to the present embodiment. The two bar graphs on the center show the collapse rate when the peripheral flow rate Fb is higher than the central flow rate Fa, and the two bar graphs on the right side show the collapse rate when the peripheral flow rate Fb is lower than the central flow rate Fa. On each of the left side, the center, and the right side, the two bar graphs show the collapse rates at the central portion and the peripheral edge portion of the first main surface Wa of the substrate W, respectively.

As illustrated in FIG. 8, in the comparative example, the collapse rate of the pattern at the peripheral edge portion increases. More specifically, in the comparative example, although the collapse rate of the pattern at the central portion is low, the collapse rate of the pattern of the central portion is higher. The reason for this is not necessarily clear, but can be considered as follows. First, it is considered that a small amount of rinse liquid (for example, pure water) remains in a liquid film of the drying liquid on the first main surface Wa at the end point of the drying liquid supply step. In the comparative example, in the drying step, the first main surface Wa of the substrate W starts to be exposed from the central portion, and the dried region expands outward over time. Since the remaining rinse liquid moves through the liquid film of the drying liquid, it is considered that the rinse liquid moves to the side of the peripheral edge of the substrate W and accumulates at the peripheral edge portion of the substrate W. It is considered that the rinse liquid accumulates at the peripheral edge portion of the substrate W and then evaporates, which increases the collapse rate of the pattern at the peripheral edge portion of the substrate W.

Further, the reason can also be considered as follows. In other words, in the drying liquid supply step, there is a possibility that the drying liquid cannot sufficiently penetrate into the pattern at the peripheral edge portion of the substrate W, and thus the rinse liquid cannot be sufficiently discharged from the inside of the pattern. In this case, the amount of the rinse liquid remaining inside the pattern at the peripheral edge portion increases, and the collapse rate of the pattern at the peripheral edge portion increases in the drying step.

In contrast, in the present embodiment, the collapse rate of the pattern at the peripheral edge portion can be reduced. Specifically, as illustrated in FIG. 8, although the collapse rate of the pattern at the central portion is slightly increased, the collapse rate of the pattern at the peripheral edge portion can be reduced. The reason for this is considered as follows. In other words, since the middle region Wa2 is first exposed (or dried) in the drying step, the rinse liquid in the liquid film of the drying liquid on the central region Wa1 cannot move much to the peripheral edge region Wa3. For this reason, it is considered that the rinse liquid does not accumulate much at the peripheral edge portion of the substrate W, and thus the collapse rate of the pattern at the peripheral edge portion is improved. Note that this consideration is considered to have a certain degree of validity, as evidenced by the fact that the collapse rate of the pattern at the central portion increases as illustrated in FIG. 8.

Alternatively, in the drying liquid supply step, the drying liquid also lands at the peripheral liquid landing position, so that there is also a possibility that the drying liquid penetrates into the pattern even at the peripheral edge portion, and the rinse liquid can be sufficiently discharged from the inside of the pattern at the peripheral edge portion.

As described above, according to the present embodiment, the collapse rate of the pattern at the peripheral edge portion can be reduced. Further, as can be understood from FIG. 8, in the present embodiment, it is also possible to reduce the difference between the collapse rate at the central portion and the collapse rate at the peripheral edge portion. In other words, the collapse rate of the pattern on the first main surface Wa can be made more uniform.

Further, since the substrate heating unit 4 heats the second main surface Wb of the substrate W in the drying liquid supply step, the temperature of the drying liquid on the first main surface Wa of the substrate W can be increased. For this reason, the temperature of the drying liquid can be increased also in the subsequent drying step. Therefore, the evaporation of the drying liquid can be promoted while reducing the surface tension of the drying liquid. If the drying liquid can be evaporated in a shorter time, it is possible to reduce an impulse on the pattern due to the surface tension of the drying liquid during evaporation. For this reason, the collapse rate of the pattern can be further reduced.

Further, the substrate heating unit 4 heats the substrate W by dispensing the heat medium from the nozzle 40 toward the central portion of the second main surface of the substrate W. According to this, the substrate W can be heated with a simple configuration.

Further, as can be understood from the comparison between the bar graph on the center and the bar graph on the right side in FIG. 8, in the drying liquid supply step, when the peripheral flow rate Fb is higher than the central flow rate Fa, the collapse rate of the pattern at the peripheral edge portion can be further reduced. Consequently, the difference between the collapse rate of the pattern at the central portion and the collapse rate of the pattern at the peripheral edge portion can be further reduced.

Further, in the example described above, in the drying step, the opposing member 60 dispenses a high-temperature inert gas toward the first main surface Wa of the substrate W. The high-temperature inert gas can promote the evaporation of the drying liquid on the first main surface Wa of the substrate W, so that the drying liquid can be evaporated in a shorter time.

Further, the opposing member 60 dispenses a high-temperature inert gas toward the central portion of the substrate W. In this case, the high-temperature inert gas hits the central portion of the first main surface Wa of the substrate W, and then flows radially outward along the first main surface Wa. According to this, the evaporation of the drying liquid on the central portion of the substrate W can be particularly promoted. In the example described above, the drying liquid on the central portion evaporates last. In other words, it is possible to intensively supply the high-temperature inert gas to the drying liquid on the region where the drying liquid evaporates last. For this reason, the drying time required for drying the first main surface Wa of the substrate W can be more effectively shortened.

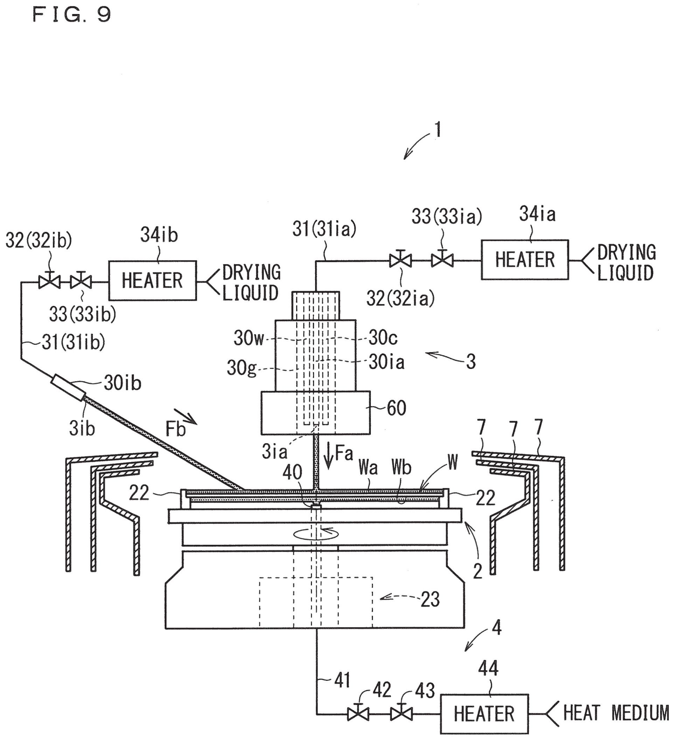

Note that, the dispenser 3 may dispense a high-temperature drying liquid. FIG. 9 is a diagram schematically illustrating another example of a part of the processing unit 1 according to the first embodiment. In the example of FIG. 9, the dispenser 3 further includes a heater 34ia and a heater 34ib. The heater 34ia is provided in the supply pipe 31ia, and heats the drying liquid flowing through the supply pipe 31ia. The heater 34ib is provided in the supply pipe 31ib, and heats the drying liquid flowing through the supply pipe 31ib. The heater 34ia and the heater 34ib are controlled by the control unit 90. Each of the heater 34ia and the heater 34ib heats the drying liquid so that the temperature of the drying liquid is higher than normal temperature and lower than the boiling point of the drying liquid. For example, each of the heater 34ia and the heater 34ib may raise the temperature of the drying liquid to 60 degrees Celsius or higher, and as a specific example, may raise the temperature to about 70 degrees Celsius.

An example of the operation of the processing unit 1 of FIG. 9 is also similar to that of FIG. 4, but in the drying liquid supply step (step S5), the dispenser 3 dispenses the heated drying liquid from the dispense port 3ia and the dispense port 3ib. For this reason, the temperature of the drying liquid on the first main surface Wa of the substrate W can be further increased. Therefore, the evaporation of the drying liquid can be further promoted while further reducing the surface tension of the drying liquid in the subsequent drying step (step S6).

Further, in the example described above, although the nozzle 30c and the nozzle 30w are provided inside the opposing member 60, at least one of them may be provided outside the opposing member 60. In this case, a movement drive unit similar to the movement drive unit 35, which moves at least one of the nozzle 30c and the nozzle 30w between the processing position and the standby position, can be separately provided.

### <Second Embodiment>

In the first embodiment, the drying liquid is caused to land not only at the central liquid landing position but also at the peripheral liquid landing position. This tends to lead to an increase in the total flow rate of the drying liquid (that is, the sum of the central flow rate Fa and the peripheral flow rate Fb). In order to avoid this increase, it is necessary to set each of the central flow rate Fa and the peripheral flow rate Fb to small values. If the central flow rate Fa decreases, the liquid film of the drying liquid on the first main surface Wa becomes thinner, and the coverage of the first main surface Wa of the substrate W by the drying liquid decreases. As a result, many particles may adhere to the first main surface Wa of the substrate W.

Therefore, in the second embodiment, it is intended to reduce the number of particles adhering to the first main surface Wa while reducing the collapse rate of the pattern at the peripheral edge portion of the substrate W.

An example of the configuration of the substrate processing apparatus 100 according to the second embodiment is similar to that of the first embodiment. Further, an example of the operation of the processing unit 1 is also as illustrated in FIG. 4. However, in the drying liquid supply step, the processing unit 1 changes the central flow rate Fa and the peripheral flow rate Fb over time.

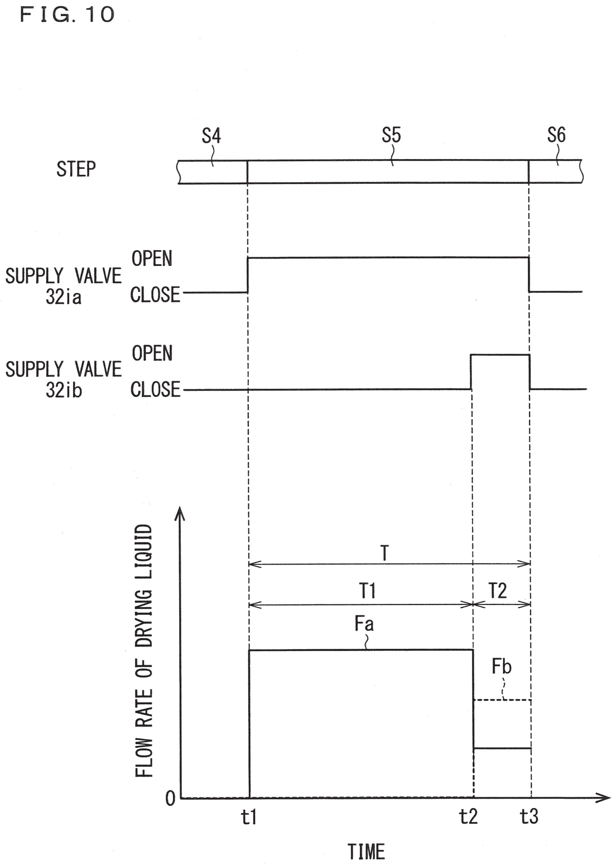

FIG. 10 is a diagram illustrating an example of a timing chart of the processing unit 1 according to the second embodiment and a temporal change in the flow rate of the drying liquid. In FIG. 10, the central flow rate Fa is indicated by a solid line, and the peripheral flow rate Fb is indicated by a broken line. In the example of FIG. 10, the control unit 90 switches the supply valve 32ia from the closed state to the open state at a time point t1. As a result, the drying liquid starts to be dispensed from the nozzle 30ia toward the central liquid landing position of the first main surface Wa of the substrate W. At this time point t1, a substantial drying liquid supply step starts. On the other hand, in the example of FIG. 10, the supply valve 32ib remains in the closed state. For this reason, the drying liquid is not yet dispensed from the nozzle 30ib.

Further, for example, at the time point t1, the control unit 90 switches the supply valve 42 from the closed state to the open state and activates the heater 44. As a result, a high-temperature heat medium is dispensed from the nozzle 40 toward the second main surface Wb of the substrate W, and thus the substrate W is heated.

Then, the control unit 90 switches the supply valve 32ib from the closed state to the open state at a time point t2, which is later than the time point t1. As a result, the drying liquid starts to be dispensed from the nozzle 30ib toward the peripheral liquid landing position on the first main surface Wa of the substrate W. In other words, the drying liquid is dispensed from both the nozzle 30ia and the nozzle 30ib.

In the example of FIG. 10, at the time point t2, the control unit 90 causes the flow rate control valve 33ia to reduce the central flow rate Fa. This makes it possible to suppress an increase in the sum of the central flow rate Fa and the peripheral flow rate Fb.

Then, the control unit 90 switches the supply valve 32ia, the supply valve 32ib, and the supply valve 42 from the open state to the closed state at a time point t3, which is later than the time point t2. In other words, at the time point t3, the substantial drying liquid supply step ends.

As described above, during a drying liquid supply time T from the time point t1 to the time point t3, the central flow rate Fa is higher than the peripheral flow rate Fb during a predetermined former time period T1 from the time point t1 to the time point t2. For example, the peripheral flow rate Fb may be half or less, 1/3 or less, 1/4 or less, or 1/10 or less of the central flow rate Fa. In the example described above, the peripheral flow rate Fb is set to zero. For this reason, more drying liquid can land at the central liquid landing position, and the entire surface of the first main surface Wa of the substrate W can be covered with higher coverage. Therefore, it is possible to suppress adhesion of particles to the first main surface Wa of the substrate W.

On the other hand, the central flow rate Fa during a latter time period T2 (a time period from the time point t2 to the time point t3 in the drawing), which is after the former time period T1 of the drying liquid supply time T, is lower than the central flow rate Fa during the former time period T1, and the peripheral flow rate Fb during the latter time period T2 is higher than the peripheral flow rate Fb during the former time period T1. For this reason, it is possible to cause the drying liquid to land at each of the central liquid landing position and the peripheral liquid landing position while suppressing an increase in the total flow rate, which is the sum of the central flow rate Fa and the peripheral flow rate Fb, that is, while suppressing an increase in the amount of the drying liquid used.

The latter time period T2 may be set shorter than the former time period T1. The latter time period T2 may be set to a half or less, 1/3 or less, 1/4 or less, or 1/10 or less of the drying liquid supply time T. As a specific example, the latter time period T2 may be set to 3 seconds or less. The shorter the latter time period T2, the longer the former time period T1 can be set. According to this, the processing unit 1 can more effectively promote the replacement of the rinse liquid with the drying liquid while more reliably suppressing the adhesion of particles.

As illustrated in FIG. 10, the end point (time point t3) of the latter time period T2 may be the end point of the drying liquid supply time T. In other words, when the latter time period T2 elapses, the control unit 90 may close the supply valve 32ia and the supply valve 32ib to stop supply of the drying liquid.

As described above, in the second embodiment, the central flow rate Fa is higher than the peripheral flow rate Fb during the former time period T1. For this reason, the drying liquid can cover the entire first main surface Wa of the substrate W with high coverage, and the adhesion of particles to the first main surface Wa of the substrate W can be appropriately suppressed.

Moreover, during the latter time period T2, the drying liquid lands at the peripheral liquid landing position of the first main surface Wa of the substrate W at a higher peripheral flow rate Fb. Further, in the second embodiment, in the drying liquid supply step, the substrate heating unit 4 heats the second main surface Wb of the substrate W. For this reason, in the subsequent drying step, the middle region Wa2 of the substrate W can be dried before the central region Wa1.Therefore, the collapse rate of the pattern in the peripheral edge portion of the substrate W can be reduced.

Further, in the example of FIG. 10, the peripheral flow rate Fb is set to be higher than the central flow rate Fa during the latter time period T2. According to this, as described in the first embodiment, the collapse rate of the pattern in the peripheral edge portion of the substrate W can be further reduced.

### <Third Embodiment>

In the first embodiment and the second embodiment, the substrate heating unit 4 heats the second main surface Wb of the substrate W throughout the entire drying liquid supply time in the drying liquid supply step (step S5). However, the present invention is not necessarily limited thereto.

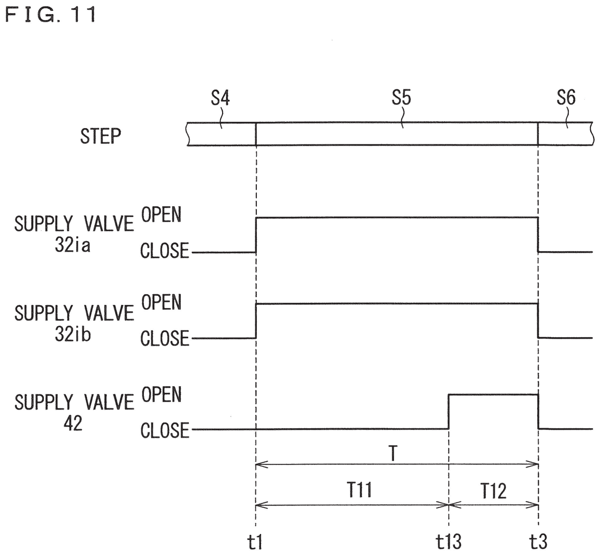

FIG. 11 is a diagram schematically illustrating an example of a timing chart of the processing unit 1 according to the third embodiment. In the example of FIG. 11, at a time point t1, the control unit 90 switches the supply valve 32ia and the supply valve 32ib from the closed state to the open state. As a result, the drying liquid starts to be dispensed from the nozzle 30ia and the nozzle 30ib toward the first main surface Wa of the substrate W. In other words, the substantial drying liquid supply step starts at the time point t1. On the other hand, in the example of FIG. 11, the control unit 90 switches the supply valve 42 from the closed state to the open state at a time point t13, which is later than the time point t1. As a result, a high-temperature heat medium starts to be dispensed from the nozzle 40 toward the second main surface Wb of the substrate W. In other words, the substrate heating unit 4 starts heating the second main surface Wb of the substrate W. Then, the control unit 90 switches the supply valve 32ia, the supply valve 32ib, and the supply valve 42 from the open state to the closed state at a time point t3, which is later than the time point t13. In other words, at the time point t3, the substantial drying liquid supply step ends.

As described above, in the third embodiment, during a drying liquid supply time T from the time point t1 to the time point t3, the substrate heating unit 4 does not heat the second main surface Wb of the substrate W during a predetermined former time period T11 from the time point t1 to the time point t13, but heats the second main surface Wb of the substrate W at a predetermined latter time period T12 from the time point t13 to the time point t3. The latter time period T12 is set in advance to a time period during which the temperature of the first main surface Wa of the substrate W at the time point t3 is sufficiently close to the boiling point of the drying liquid. For example, the latter time period T12 may be set to a half or less of the drying liquid supply time T, may be set to 1/3 or less, 1/4 or less, or 1/10 or less of the drying liquid supply time T.

As described above, in the third embodiment, the substrate heating unit 4 does not heat the substrate W during the former time period T11, but heats the second main surface Wb of the substrate W during the latter time period T12. In other words, the substrate heating unit 4 heats the second main surface Wb of the substrate W only during the latter time period T12. For this reason, an operation time of the substrate heating unit 4 can be shortened, and the power consumption of the substrate processing apparatus 100 can be reduced. Further, in a case where the substrate heating unit 4 supplies a high-temperature heat medium to the second main surface Wb of the substrate W, the amount of heat medium used can be reduced. In a case where the heat medium is a liquid, liquidsaving can be achieved.

Note that, in the third embodiment, in a case where the second embodiment is applied as the timing for opening the supply valve 32ib, the latter time period T12 may be the same as or different from the latter time period T2.

### <Fourth Embodiment>

The configuration of the substrate processing apparatus 100 according to the fourth embodiment is similar to that of the first embodiment. However, in the fourth embodiment, in the drying liquid supply step (step S5), the substrate heating unit 4 raises the temperature of at least a part (for example, the central portion) of the second main surface Wb of the substrate W to a temperature equal to or higher than the boiling point of the drying liquid. Specifically, the substrate heating unit 4 supplies a heat medium having a temperature equal to or higher than the boiling point of the drying liquid to the central portion of the second main surface Wb of the substrate W.

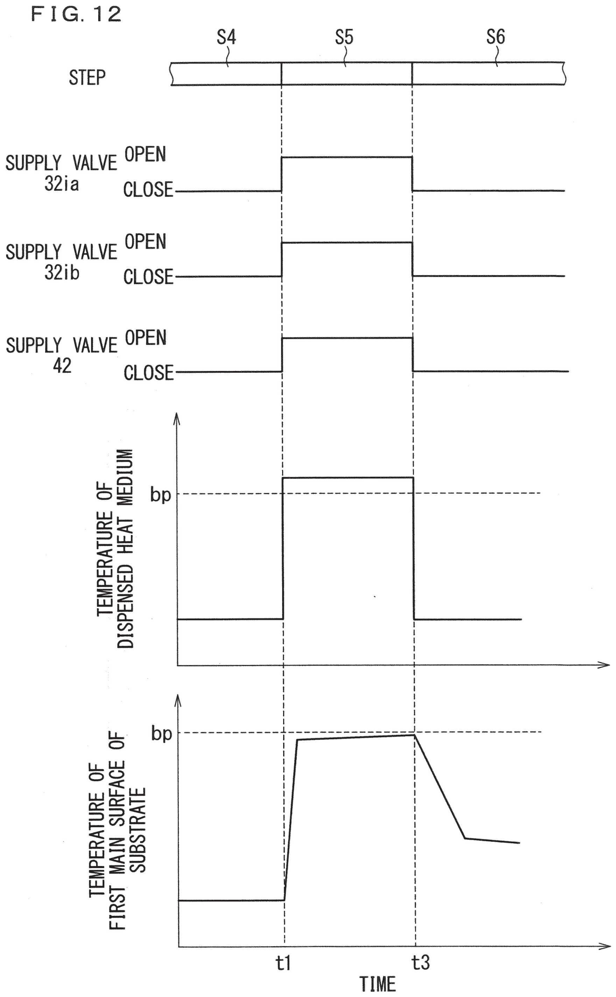

FIG. 12 is a diagram schematically illustrating an example of a timing chart of the processing unit 1 according to the fourth embodiment, and temporal changes in the flow rate of the heat medium, the temperature of the heat medium, and the temperature of the first main surface Wa of the substrate W (hereinafter, referred to as a substrate temperature). In the example of FIG. 12, in the drying liquid supply step (step S5), the temperature of the heat medium dispensed from the nozzle 40 is higher than a boiling point bp of the drying liquid. In a case where the drying liquid is isopropyl alcohol, the boiling point bp is 82.4 degrees Celsius, and the temperature of the heat medium is set to, for example, about 85 degrees Celsius. However, the temperature of the heat medium can be set to be lower than the boiling point of the heat medium. For example, in a case where the heat medium is water, the temperature may be set to below 90 degrees Celsius that is 10 degrees lower than the boiling point (100 degrees Celsius). According to this, it is possible to comply with SEMI standards.

In the drying liquid supply step, a drying liquid having a temperature lower than that of the heat medium is dispensed from the nozzle 30ia and the nozzle 30ib. For this reason, a drying liquid with a low temperature is continuously supplied to the first main surface Wa of the substrate W. Therefore, the drying liquid with a low temperature can cool the first main surface Wa of the substrate W. A cooling capacity of the drying liquid increases as the central flow rate Fa and the peripheral flow rate Fb of the drying liquid increase. Therefore, the flow rate control valve 33ia and the flow rate control valve 33ib respectively adjust the central flow rate Fa and the peripheral flow rate Fb of the drying liquid to values at which the substrate temperature is lower than the boiling point bp. Since the drying liquid landing at the central liquid landing position flows over the entire surface of the first main surface Wa of the substrate W, the central flow rate Fa is particularly important. For example, the central flow rate Fa of the drying liquid is set in advance to about 100 mL/min or higher.

In the example of FIG. 12, the temperature of the central portion of the first main surface Wa of the substrate W is illustrated as the substrate temperature of the first main surface Wa of the substrate W. Since the high-temperature heat medium lands at the central portion of the second main surface Wb of the substrate W, the substrate temperature of the substrate W has a temperature distribution to be described below. In other words, the substrate temperature is higher at the central portion of the substrate W and decreases radially outward. For this reason, in the example of FIG. 12, the highest value in the temperature distribution of the first main surface Wa of the substrate W is illustrated as the substrate temperature.

As illustrated in FIG. 12, the substrate temperature in the drying liquid supply step is lower than the boiling point bp of the drying liquid. In a case where the drying liquid is isopropyl alcohol, the highest substrate temperature in the temperature distribution of the substrate W can be adjusted to, for example, about 80 degrees Celsius or lower. For this reason, boiling of the drying liquid in the drying liquid supply step can be more reliably suppressed. If the drying liquid on the first main surface Wa of the substrate W boils during supply, it will cause particles to adhere to the first main surface Wa. In the present embodiment, since the boiling of the drying liquid is more reliably suppressed, the adhesion of particles to the first main surface Wa of the substrate W can be more reliably suppressed.

Moreover, in the fourth embodiment, the temperature of the heat medium dispensed in the drying liquid supply step is equal to or higher than the boiling point bp. For this reason, in the drying liquid supply step, a maximum value in the temperature distribution of the first main surface Wa of the substrate W can be brought closer to the boiling point bp. A minimum value in the temperature distribution of the first main surface Wa of the substrate W in the drying liquid supply step (that is, the substrate temperature at the peripheral edge portion of the first main surface Wa) is, for example, 60 degrees Celsius or higher. In other words, the flow rate of the drying liquid can be set such that the substrate temperature at each position of the first main surface Wa of the substrate W is 60 degrees Celsius or higher and lower than the boiling point bp of the drying liquid.

In the fourth embodiment, in the drying liquid supply step, the temperature of the drying liquid on the first main surface Wa of the substrate W can be brought closer to the boiling point bp while increasing the temperature of the substrate W itself. For this reason, the temperature of the drying liquid can be further increased in the drying step immediately after the supply of the drying liquid is stopped. For this reason, in the drying step, it is possible to further increase an evaporation rate of the drying liquid while further reducing the surface tension of the drying liquid. Further, since the drying liquid can be evaporated at an earlier timing immediately after the start of the drying step, it is considered that the drying liquid on the middle region Wa2 quickly evaporates while remaining as a thin liquid film. For this reason, it is considered that the middle region Wa2 can be more reliably exposed earlier than the center region Wa1.

### <Fifth Embodiment>

In the example described above, the processing unit 1 performs the chemical liquid step (step S3), the rinse step (step S4), the drying liquid supply step (step S5), and the drying step (step S6) in this order. However, the present invention is not necessarily limited thereto.

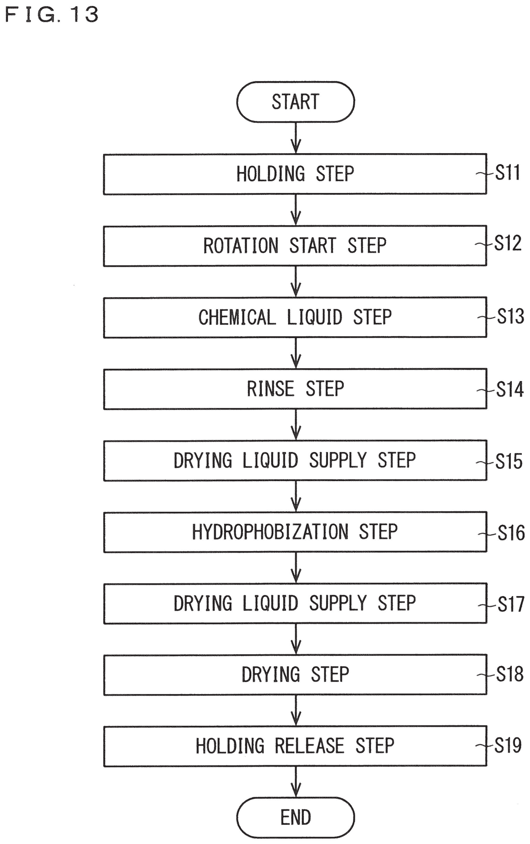

FIG. 13 is a flowchart illustrating a first example of an operation of the processing unit 1 according to the fifth embodiment. In the example of FIG. 13, the control unit 90 causes the processing unit 1 to execute the processing of steps S11 to S19 in accordance with a preset processing procedure (recipe). Steps S11 to S15 are similar to steps S1 to S5, respectively. However, in step S15 (the drying liquid supply step), the substrate heating unit 4 does not need to heat the substrate W.

Next, the processing unit 1 hydrophobizes the first main surface Wa of the substrate W (step S16: hydrophobization step: corresponding to a liquid supply step). Specifically, the processing unit 1 includes a nozzle that dispenses a hydrophobizing liquid, and causes the hydrophobizing liquid to be dispensed from the nozzle to the first main surface Wa of the rotating substrate W. The hydrophobizing liquid includes, for example, a silicon-based hydrophobizing liquid. The silicon-based hydrophobizing liquid is a hydrophobizing liquid that hydrophobizes silicon (Si) itself and a compound containing silicon. The hydrophobizing liquid is, for example, a silylation liquid containing a liquid silylating agent (also referred to as a silane coupling agent). The processing unit 1 stops the dispense of the hydrophobizing liquid from the nozzle when the first main surface Wa of the substrate W is sufficiently hydrophobized.

Next, the processing unit 1 executes steps S17 to S19. Steps S17 to S19 are similar to steps S5 to S7, respectively.

As described above, also in the first example described above, the drying liquid supply step (step S17) is executed in the same manner as the drying liquid supply step (step S5) in the first to fourth embodiments. For this reason, the collapse rate of the pattern of the substrate W can be reduced. Moreover, since the first main surface Wa of the substrate W is hydrophobized, a contact angle of the first main surface Wa can be reduced. For this reason, the surface tension acting on the pattern can be reduced, and the collapse rate of the pattern can be further reduced.

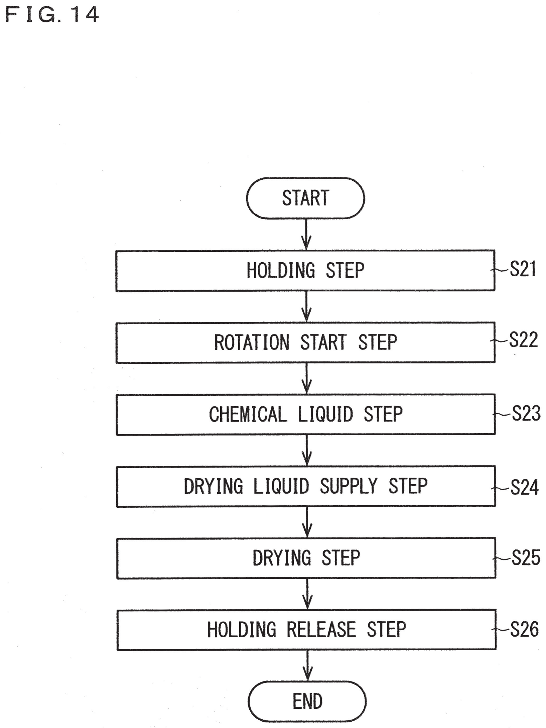

FIG. 14 is a flowchart illustrating a second example of the operation of the processing unit 1 according to the fifth embodiment. In the example of FIG. 14, the control unit 90 causes the processing unit 1 to execute the processing of steps S21 to S26 in accordance with a preset processing procedure (recipe). Steps S21 to S26 are similar to steps S1 to S3 and steps S5 to S7, respectively. However, at the end point of step S23 (the chemical liquid step: corresponding to a liquid supply step), metal is exposed on the first main surface Wa of the substrate W. According to the second example, after step S23, step S24 (the drying liquid supply step) is performed. For this reason, water is not supplied to the first main surface Wa of the substrate W. Therefore, a reaction between the metal and water can be avoided, and defects caused by the reaction can be avoided. Further, in the second example described above, the drying liquid supply step (step S24) is performed in the same manner as the drying liquid supply step (step S5) in the first to fourth embodiments. For this reason, the collapse rate of the pattern of the substrate W can be reduced.

### <Sixth Embodiment>

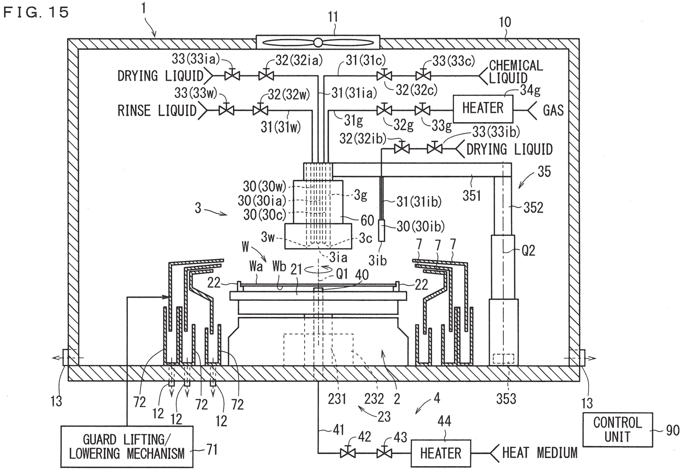

FIG. 15 is a diagram schematically illustrating a first example of the configuration of the processing unit 1 according to the sixth embodiment. The processing unit 1 according to the first example is different from the processing unit 1 according to the first embodiment in terms of the nozzle 30ib.

In the example of FIG. 15, the nozzle 30ib is provided to be movable integrally with the dispense head by the movement drive unit 35. Specifically, the nozzle 30ib is connected to the arm 351 of the movement drive unit 35. The nozzle 30ib faces the first main surface Wa of the substrate W held by the substrate holding unit 2 in the vertical direction in a state where the dispense head is located at the processing position. Specifically, the nozzle 30ib faces the peripheral edge portion of the first main surface Wa in the vertical direction. The nozzle 30ib extends in the vertical direction, and the dispense port 3ib is formed on the lower surface thereof. The nozzle 30ib dispenses the drying liquid from the dispense port 3ib, for example, vertically downward.

The operation of the processing unit 1 according to the first example is also similar to that shown in the flowchart of FIG. 4. In other words, the drying liquid supply step (step S5) is performed in the same manner as in the first to fourth embodiments. For this reason, the collapse rate of the pattern at the peripheral edge portion of the substrate W can be reduced.

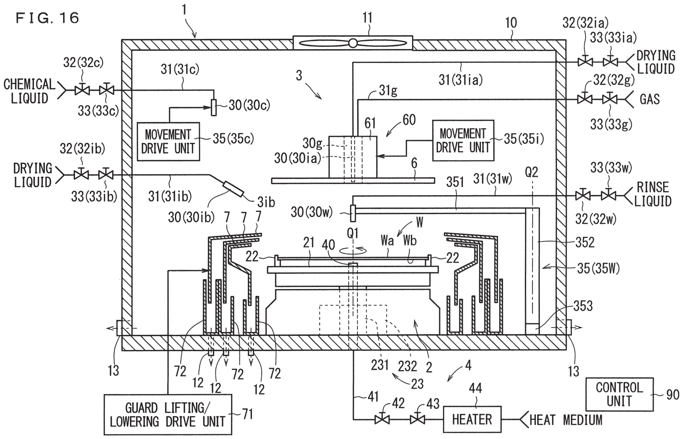

FIG. 16 is a diagram schematically illustrating a second example of the configuration of the processing unit 1 according to the sixth embodiment. The processing unit 1 according to the second example is different from the processing unit 1 according to the first embodiment in the configuration of the dispenser 3 and the opposing member 60. In the example of FIG. 16, the opposing member 60 includes a shielding plate 6 and a hollow shaft 61. The shielding plate 6 is provided at a position facing the first main surface Wa of the substrate W held by the substrate holding unit 2 in the vertical direction. In the example of FIG. 16, since the first main surface Wa of the substrate W corresponds to the upper surface, the shielding plate 6 is provided vertically above the substrate W. The shielding plate 6 has, for example, a plate-like shape, and is provided in an orientation in which the thickness direction thereof is along the vertical direction. The lower surface of the shielding plate 6 is an opposing surface that faces the first main surface Wa of the substrate W. The shielding plate 6 has, for example, a circular shape in plan view. The diameter of the shielding plate 6 (that is, the diameter of the opposing surface) may be, for example, 80% or more, 90% or more of the diameter of the substrate W, or equal to or more than the diameter of the substrate W.

In the example of FIG. 16, a hollow shaft 61 is provided on the upper surface of the shielding plate 6. The hollow shaft 61 has a hollow portion, and a through hole that penetrates the shielding plate 6 in the vertical direction is formed in the central portion of the shielding plate 6. The hollow portion is connected to the through hole of the shielding plate 6 in the vertical direction. The nozzle 30ia is provided in the hollow portion of the hollow shaft 61 and the through hole of the shielding plate 6. The diameter of an outer peripheral surface of the nozzle 30i is smaller than the diameter of the inner peripheral surfaces of the hollow shaft 61 and the shielding plate 6. A space between the outer peripheral surface of the nozzle 30i and the inner peripheral surfaces of the hollow shaft 61 and the shielding plate 6 functions as the gas flow path 30g.

In the example of FIG. 16, the nozzle 30c and the nozzle 30w are provided outside the opposing member 60. Further, in the example of FIG. 16, a movement drive unit 35c and a movement drive unit 35w are provided as the movement drive unit 35. The movement drive unit 35c moves the nozzle 30c between the processing position and the standby position, and the movement drive unit 35w moves the nozzle 30w between the processing position and the standby position.

In the example of FIG. 16, a movement drive unit 35i is provided as the movement drive unit 35. The movement drive unit 35i integrally moves the nozzle 30ia and the opposing member 60. The movement drive unit 35i integrally moves the nozzle 30ia and the opposing member 60, for example, along the vertical direction. In this case, it can be said that the movement drive unit 35i is a lifting/lowering drive unit. The movement drive unit 35i includes a drive source such as a motor and a power transmission unit that transmits power from the drive source to the nozzle 30ia and the shielding plate 6. The power transmission unit includes, for example, a cam mechanism or a ball screw mechanism.

The operation of the processing unit 1 according to the second example is also similar to that shown in the flowchart of FIG. 4. However, the movement drive unit 35i lowers the nozzle 30ia and the opposing member 60 to a processing position closer to the substrate W in the drying liquid supply step and the drying step, and lifts them to a standby position higher than the processing position in the other steps.

Also in the second example of the sixth embodiment, the drying liquid supply step (step S5) in the first to fourth embodiments is executed. For this reason, the collapse rate of the pattern at the peripheral edge portion of the substrate W can be reduced.

As described above, the substrate processing apparatus 100 and the substrate processing method have been described in detail, but the above description is illustrative in all aspects, and the present disclosure is not limited thereto. Further, the various modifications described above can be applied in combination as long as they do not contradict each other. It is understood that numerous modifications not illustrated can be assumed without departing from the scope of the present disclosure.

In the examples described above, a dedicated nozzle is provided for each fluid, but one nozzle may be shared by different types of fluids.

Further, in the examples described above, the substrate heating unit 4 supplies a heat medium to the second main surface Wb of the substrate W, but the present invention is not necessarily limited thereto. The substrate heating unit 4 may include, for example, a heater provided at a position facing the second main surface Wb of the substrate W in the vertical direction. The heater may be, for example, an electric resistance type heater including an electric heating wire, or may be an optical type heater that outputs light for heating.

### EXPLANATION OF REFERENCE SIGNS

2: substrate holding unit
3: dispenser
3ia: first dispense port (dispense port)
3ib: second dispense port (dispense port)
4: substrate heating unit
bp: boiling point
Fa: central flow rate
Fb: peripheral flow rate
S1: holding step (step)
S4, S16, S23: liquid processing step (step)
S5, S17, S24: drying liquid supply step (step)
S6, S18, S25: drying step (step)
T: drying liquid supply time
T1, T11: former time period
T2, T12: latter time period
W: substrate
Wa: first main surface
Wa2: middle region
Wb: second main surface

## Claims

1. A substrate processing method comprising:
a holding step of holding a substrate having a first main surface on which a pattern is formed and a second main surface on a side opposite to said first main surface;
a liquid processing step of supplying a processing liquid to said first main surface of said substrate;
a drying liquid supply step of supplying a drying liquid having a surface tension lower than that of said processing liquid to said first main surface of said substrate while rotating said substrate and heating said second main surface of said substrate after said liquid processing step; and
a drying step of drying said substrate by evaporating said drying liquid on said first main surface of said substrate after said drying liquid supply step,
wherein during at least a part of said drying liquid supply step, said drying liquid is dispensed from a first dispense port of a dispenser to land at a central portion of said first main surface of said substrate while said drying liquid is dispensed from a second dispense port of said dispenser to land at a peripheral edge portion of said first main surface of said substrate.

2. The substrate processing method according to claim 1, wherein
in said drying step, a middle region located between said central portion and said peripheral edge portion of said first main surface of said substrate is dried before said central portion.

3. The substrate processing method according to claim 1 or 2, wherein
in said drying liquid supply step, said drying liquid heated is dispensed from said first dispense port and said second dispense port.

4. The substrate processing method according to claim 1 or 2, wherein
in said drying liquid supply step, a central flow rate of said drying liquid dispensed from said first dispense port is lower than a peripheral flow rate of said drying liquid dispensed from said second dispense port during at least a latter time period of a drying liquid supply time during which said drying liquid is supplied to said first main surface of said substrate.

5. The substrate processing method according to claim 1 or 2, wherein
in said drying liquid supply step, a central flow rate of said drying liquid from said first dispense port is higher than a peripheral flow rate of said drying liquid from said second dispense port during a former time period of a drying liquid supply time during which said drying liquid is supplied to said first main surface of said substrate, and said peripheral flow rate during a latter time period after said former time period is higher than said peripheral flow rate during said former time period.

6. The substrate processing method according to claim 5, wherein
said central flow rate during said latter time period is lower than said central flow rate during said former time period.

7. The substrate processing method according to claim 5, wherein
said latter time period is shorter than said former time period.

8. The substrate processing method according to claim 1 or 2, wherein
in said drying liquid supply step, a heat medium is supplied to a central portion of said second main surface of said substrate to heat said substrate.

9. The substrate processing method according to claim 1 or 2, wherein
in said drying step, a heated inert gas is supplied to a central portion of said first main surface of said substrate.

10. The substrate processing method according to claim 1 or 2, wherein
in said drying liquid supply step, said second main surface of said substrate is heated so that a temperature of at least a portion of said second main surface of said substrate is equal to or higher than a boiling point of said drying liquid while said drying liquid is supplied to said first main surface of said substrate at a flow rate at which the temperature of said first main surface of said substrate is lower than said boiling point.

11. The substrate processing method according to claim 1 or 2, wherein
in said drying liquid supply step, said second main surface of said substrate is heated only during a latter time period of a drying liquid supply time during which said drying liquid is supplied.

12. A substrate processing apparatus comprising:
a substrate holder that rotates a substrate having a first main surface on which a pattern is formed and a second main surface on a side opposite to said first main surface while holding said substrate;
a dispenser that dispenses a processing liquid to said first main surface of said substrate held by said substrate holder; and
a substrate heater that heats said second main surface of said substrate held by said substrate holder,
wherein said dispenser includes a first dispense port that dispenses a drying liquid toward a central portion of said first main surface of said substrate held by said substrate holder, and a second dispense port that dispenses said drying liquid toward a peripheral edge portion of said first main surface of said substrate held by said substrate holder.
